# EUROPÄISCHE PATENTSCHRIFT

(11) **EP 4 771 348 B1**
(45) Veröffentlichungstag und Bekanntmachung des Hinweises auf die Patenterteilung: **09.12.2026**
(21) Anmeldenummer: 24764819.9
(22) Anmeldetag: 28.08.2024
(51) Int. Cl.: G01L 1/24, G01L 5/00, G01L 5/166, G01L 5/22, G01R 31/28

(54) **SYSTEM UND VERFAHREN ZUR AUSRICHTUNG EINES ERSTEN OBJEKTS ZU EINEM ZWEITEN OBJEKT**
FORCE-DETERMINING APPARATUS, FORCE-DETERMINING METHOD, SYSTEM AND METHOD FOR ALIGNING A FIRST OBJECT WITH A SECOND OBJECT
DISPOSITIF DE DÉTERMINATION DE FORCE, PROCÉDÉ DE DÉTERMINATION DE FORCE, SYSTÈME ET PROCÉDÉ POUR ORIENTER UN PREMIER OBJET PAR RAPPORT À UN DEUXIÈME OBJET

(30) Priorität: 28.08.2023 DE 102023123066
(43) Veröffentlichungstag der Anmeldung: 08.07.2026
(73) Patentinhaber: SmarAct Holding GmbH, 26135 Oldenburg (DE)
(72) Erfinder: HÜLSEN, Helge, 26133 Oldenburg (DE)
(74) Vertreter: Eisenführ Speiser
(86) Internationale Anmeldenummer: PCT/EP2024/074091
(87) Internationale Veröffentlichungsnummer: WO 2025/045954

(56) Entgegenhaltungen:
- WO-A1-2023/114729
- JP-A- 2022 143 176
- US-A- 4 676 649
- US-A1- 2003 213 382
- US-A1- 2015 276 518
- US-A1- 2016 041 049
- US-A1- 2018 099 421
- US-B2- 9 995 644

## Beschreibung

Die vorliegende Erfindung betrifft das Gebiet der Halbleitertechnik, insbesondere ein Ausrichten flächiger Objekte im Halbleiterbereich, zum Beispiel Wafer, Masken, Probe Cards, Flächengreifer und/oder Substrate. Insbesondere kann die vorliegende Erfindung alle Gebiete betreffen, in denen Bauteile, beispielsweise kompakte Bauteile oder ein kompaktes Bauteil, zu einem Substrat ausgerichtet werden sollen, wobei der Ausrichtung dann ein weiterer Verarbeitungsschritt folgen kann, zum Beispiel ein thermisches Bonden, wofür eine hohe Kraft auf das Bauteil ausgeübt werden muss.

Zum Ausrichten kann das Bauteil zum Beispiel durch einen Greifer aufgenommen werden, wobei eine Genauigkeit der Ausrichtung durch den Greifer über einen Kontakt zwischen dem Greifer und dem Bauteil (Wafer, Substrat) ermittelt werden kann. Weiter besteht der Bedarf, dass eine auf das Bauteil wirkende Kraft, zum Beispiel in weiteren Verarbeitungsschritten, möglichst homogen über den Greifer aufgebracht werden soll.

Generell ist bekannt, dass zur Ausrichtung Kinematiken verwendet werden, insbesondere Parallelkinematiken, wobei die Kinematiken 3D- oder 6D-Kinematiken entsprechen können.

US 2003/213382 A1 beschreibt Systeme zur Ausrichtung eines ersten Objekts zu einem zweiten Objekt mit einer Ausrichtungsvorrichtung, die mehrere Messwertbestimmungsvorrichtungen aufweist, wobei eine gemeinsame Struktur diese Messwertbestimmungsvorrichtungen miteinander verbindet und räumlich zueinander ausrichtet, und wobei eine Kinematik, die ausgestaltet ist, die Ausrichtungsvorrichtung in zumindest drei Freiheitsgraden zu bewegen, wobei die Kinematik ferner ausgestaltet ist, basierend auf den mehreren Messwerten das erste Objekt räumlich zu dem zweiten Objekt auszurichten.

Für die Ausrichtung eines beweglichen flächigen Objekts zu einem anderen flächigen Objekt, um entweder eine bestimmte Anpresskraft oder einen bestimmten Abstand zu erreichen, sind insbesondere die folgenden Lösungen bekannt:
Beispielsweise kann ein Spalt zwischen den flächigen Objekten optisch überwacht und ermittelt werden, zum Beispiel mit Hilfe einer Kamera, einer Lichtquelle und entsprechenden Markern (s., z.B., B. Huang, C. Wang, H. Fang, S. Zhou and T. Suga: "Moire-Based Alignment Using Centrosymmetric Grating Marks for High-Precision Wafer Bonding", Micromachines 10(5): 339, May 2019; DOI: 10.3390/mi10050339, oder M. M. R. Howlader, H. Okada, T. H. Kim, T. Itoh and T. Suga: "Wafer Level Surface Activated Bonding Tool for MEMS Packaging", Journal of The Electrochemical Society, 151(7), G461-G467, May 2004, DOI: 10.1149/1.1758723).

Weiter ist bekannt, Stresssensoren zu verwenden, wobei mit Hilfe eines Stresssensors das Berühren des gesamten Wafers im Bonding-Prozess erkannt werden kann. Stresssensoren können zum Beispiel Dehnungsmessstreifen sein (s., z.B., S. Kawashima, M. Imada, K. Ishizaki, S. Noda: "High-Precision Alignment and Bonding System for the Fabrication of 3-D Nanostructures", Journal of Microelectromechanical Systems, 2007, 16(5): 1140-1144).

Zudem können als Abstandshalter sogenannte Spacer verwendet werden, um einen vordefinierten Abstand zwischen den Objekten einzustellen. Diese werden je nach Anwendung für das Bonden entfernt (s., z.B., S. Farrens and S. Sood: "Precision Wafer to Wafer Packaging Using Eutectic Metal Bonding", suss report, July 2008, 6-11).

Die bekannten Lösungen bringen jedoch jeweils einige Nachteile mit sich. Optische Abstandsmessungen über Kameras erfordern durchsichtige Objekte mit Markern an den Messstellen sowie eine enge Toleranz zwischen den Höhen an den Messstellen und den eigentlichen Objekten, die nachher in Berührung kommen.

Stresssensoren messen nur die gesamte Kraft für den gesamten Bonding-Prozess und können flache Objekte nicht auf einen vordefinierten Abstand bringen. Sie weisen überdies auch eine geringe Auflösung auf, weil die Sensoren die manchmal hohen Kräfte beim Bonden aufnehmen müssen.

Spacer wiederum führen zu einer teilweise hohen bzw. ungleichmäßigen Belastung der Wafer, weil sie meist am Rand angebracht werden. Beim Entfernen der Spacer kann es zudem zu einem seitlichen Versatz kommen. Eine vordefinierte Kraft ist hiermit ebenfalls nicht möglich.

Es ist daher gewünscht, eine Lösung vorzustellen, die die obigen Nachteile überwindet und insbesondere eine hohe Messgenauigkeit in einem großen Messbereich mit sich bringt.

Das erfindungsgemäße System, welches weiter unten im Detail beschrieben wird, umfasst beispielsweise eine Kraftbestimmungsvorrichtung mit (i) einem Kontaktabschnitt, der ausgestaltet ist, zumindest einen Teil eines ersten Objekts zu kontaktieren, (ii) einem flexiblen Abschnitt, der mit dem Kontaktabschnitt verbunden ist, wobei der flexible Abschnitt ausgestaltet ist, nachzugeben, wenn eine Kraft zumindest teilweise auf das erste Objekt und/oder auf den Kontaktabschnitt wirkt, (iii) einem Messkopf, das ausgestaltet ist, einen Messwert einer Messgröße, die mit dem Nachgeben des flexiblen Abschnitts korreliert zu messen, und (iv) einem Kraftbestimmungsgerät, das ausgestaltet ist, basierend auf dem Messwert der Messgröße einen Kraftwert der Kraft zu bestimmen, die zumindest teilweise auf das erste Objekt und/oder auf den Kontaktabschnitt wirkt, wobei der Messkopf ein Interferometer, einen kapazitiven Messkopf oder einen optischen Encoder umfasst und/oder wobei der Messkopf ausgestaltet ist, als die Messgröße eine Abstandsänderung von 0,1 nm bis 1 µm, bevorzugt bis 100 nm, zu messen und/oder wobei die Kraftbestimmungsvorrichtung ausgestaltet ist, eine Kraft von 1 µN bis 10 mN, bevorzugt bis 1 mN zu messen.

D.h. der Messkopf umfasst ein Interferometer, einen kapazitiven Messkopf oder einen optischen Encoder. Zusätzlich oder alternativ ist der Messkopf ausgestaltet, als die Messgröße eine Abstandsänderung von 0,1 nm bis 1 µm, bevorzugt bis 100 nm, zu messen. Weiter zusätzlich oder alternativ ist die Kraftbestimmungsvorrichtung ausgestaltet, eine Kraft von 1 µN bis 10 mN, bevorzugt bis 1 mN zu messen.

Dabei kann ein Kraftbestimmungsverfahren mit den Schritten durchgeführt werden: (i) Inkontaktbringen zumindest eines Teils eines ersten Objekts mit einem Kontaktabschnitt, (ii) Nachgeben eines flexiblen Abschnitts, der mit dem Kontaktabschnitt verbunden ist, wenn eine Kraft zumindest teilweise auf das erste Objekt und/oder auf den Kontaktabschnitt wirkt, (iii) Messen eines Messwerts einer Messgröße, die mit dem Nachgeben des flexiblen Abschnitts korreliert, mit Hilfe eines Messkopfes, und (iv) Bestimmen eines Kraftwerts der Kraft, die zumindest teilweise auf das erste Objekt und/oder auf den Kontaktabschnitt wirkt, basierend auf dem Messwert der Messgröße, wobei der Messwert der Messgröße mit Hilfe eines Interferometers, eines kapazitiven Messkopfes oder eines optischen Encoders gemessen wird und/oder wobei die Messgröße eine Abstandsänderung von 0,1 nm bis 1 µm, bevorzugt bis 100 nm, umfasst und/oder wobei der Kraftwert einen Wert von 1 µN bis 10 mN, bevorzugt bis 1 mN umfasst.

Erfindungsgemäß wird nach einem Aspekt ein System zur Ausrichtung eines ersten Objekts zu einem zweiten Objekt vorgesehen, wobei das System eine Ausrichtungsvorrichtung und eine Kinematik umfasst. Die Ausrichtungsvorrichtung weist eine erste Messwertbestimmungsvorrichtung mit (i) einem ersten Kontaktabschnitt auf, der ausgestaltet ist, zumindest einen ersten Teil eines ersten Objekts zu kontaktieren, (ii) einem ersten flexiblen Abschnitt, der mit dem ersten Kontaktabschnitt verbunden ist, wobei der erste flexible Abschnitt ausgestaltet ist, nachzugeben, wenn eine Kraft zumindest teilweise auf das erste Objekt und/oder auf den ersten Kontaktabschnitt wirkt, und (iii) einem ersten Messkopf, das ausgestaltet ist, einen ersten Messwert einer Messgröße, die mit dem Nachgeben des ersten flexiblen Abschnitts korreliert, zu messen. Weiter weist die Ausrichtungsvorrichtung eine zweite Messwertbestimmungsvorrichtung mit (i) einem zweiten Kontaktabschnitt auf, der ausgestaltet ist, zumindest einen zweiten Teil eines ersten Objekts zu kontaktieren, (ii) einem zweiten flexiblen Abschnitt, der mit dem zweiten Kontaktabschnitt verbunden ist, wobei der zweite flexible Abschnitt ausgestaltet ist, nachzugeben, wenn eine Kraft zumindest teilweise auf das erste Objekt und/oder auf den zweiten Kontaktabschnitt wirkt, und (iii) einem zweiten Messkopf, das ausgestaltet ist, einen zweiten Messwert einer Messgröße, die mit dem Nachgeben des zweiten flexiblen Abschnitts korreliert, zu messen. Zudem weist die Ausrichtungsvorrichtung eine dritte Messwertbestimmungsvorrichtung mit (i) einem dritten Kontaktabschnitt auf, der ausgestaltet ist, zumindest einen dritten Teil eines ersten Objekts zu kontaktieren, (ii) einem dritten flexiblen Abschnitt, der mit dem dritten Kontaktabschnitt verbunden ist, wobei der dritte flexible Abschnitt ausgestaltet ist, nachzugeben, wenn eine Kraft zumindest teilweise auf das erste Objekt und/oder auf den dritten Kontaktabschnitt wirkt, und (iii) einem dritten Messkopf, das ausgestaltet ist, einen dritten Messwert einer Messgröße, die mit dem Nachgeben des dritten flexiblen Abschnitts korreliert, zu messen. Zudem weist die Ausrichtungsvorrichtung eine gemeinsame Struktur auf, die die erste Messwertbestimmungsvorrichtung, die zweite Messwertbestimmungsvorrichtung und die dritte Messwertbestimmungsvorrichtung miteinander verbindet und räumlich zueinander ausrichtet. Die Kinematik des Systems ist ausgestaltet, die Ausrichtungsvorrichtung in zumindest drei Freiheitsgraden zu bewegen, und weiter ausgestaltet, basierend auf dem ersten Messwert, dem zweiten Messwert und dem dritten Messwert das erste Objekt räumlich zu dem zweiten Objekt auszurichten, wobei der erste Messkopf, der zweite Messkopf und der dritte Messkopf jeweils ein Interferometer, einen kapazitiven Messkopf oder einen optischen Encoder umfasst, wobei bevorzugt der erste Messkopf, der zweite Messkopf und der dritte Messkopf identisch ausgestaltet sind, und/oder wobei der erste Messkopf, der zweite Messkopf und der dritte Messkopf jeweils ausgestaltet ist, als den jeweiligen Messwert eine Abstandsänderung von 0,1 nm bis 1 µm, bevorzugt bis 100 nm, zu messen.

Erfindungsgemäß wird nach einem weiteren Aspekt ein Verfahren zur Ausrichtung eines ersten Objekts zu einem zweiten Objekt vorgeschlagen mit den Schritten: (i) Inkontaktbringen zumindest eines Teils eines ersten Objekts mit einem ersten Kontaktabschnitt einer ersten Messwertbestimmungsvorrichtung, einem zweiten Kontaktabschnitt einer zweiten Messwertbestimmungsvorrichtung und einem dritten Kontaktabschnitt einer dritten Messwertbestimmungsvorrichtung, (ii) Nachgeben eines ersten flexiblen Abschnitts der ersten Messwertbestimmungsvorrichtung, eines zweiten flexiblen Abschnitts der zweiten Messwertbestimmungsvorrichtung und eines dritten flexiblen Abschnitts der dritten Messwertbestimmungsvorrichtung, wobei der erste flexible Abschnitt, der zweite flexible Abschnitt und der dritte flexible Abschnitt jeweils mit dem ersten Kontaktabschnitt, dem zweiten Kontaktabschnitt und dem dritten Kontaktabschnitt verbunden sind, wenn eine Kraft zumindest teilweise auf das erste Objekt und/oder auf wenigstens einen von dem ersten Kontaktabschnitt, dem zweiten Kontaktabschnitt und dem dritten Kontaktabschnitt wirkt, (iii) Messen eines ersten Messwertes, eines zweiten Messwerts und eines dritten Messwerts einer Messgröße, die mit dem jeweiligen Nachgeben des ersten flexiblen Abschnitts, des zweiten flexiblen Abschnitts und des dritten flexiblen Abschnitts korreliert, mit Hilfe eines ersten Messkopfes, eines zweiten Messkopfes und eines dritten Messkopfes, und (iv) räumliches Ausrichten des ersten Objekts zu dem zweiten Objekt basierend auf dem erste Messwert, dem zweiten Messwert und dem dritten Messwert mit Hilfe einer Kinematik, die ausgestaltet ist, das erste Objekt in zumindest drei Freiheitsgraden zu bewegen, wobei die Messwerte der Messgrößen mit Hilfe von Interferometern, kapazitiven Messköpfen oder optischen Encodern gemessen werden und/oder wobei die Messgrößen jeweils eine Abstandsänderung von 0,1 nm bis 1 µm, bevorzugt bis 100 nm, umfassen.

Die Kombination aus flexiblen Abschnitten, die als Biegewandler verstanden werden können, mit einem Messkopf, der ein Interferometer, einen kapazitiven Messkopf oder einen optischen Encoder umfasst und/oder ausgestaltet ist, eine Abstandsänderung von 0,1 nm bis 1 µm, bevorzugt bis 100 nm, zu messen (oder zusätzlich oder alternativ die Kraftbestimmungsvorrichtung ausgestaltet ist, eine Kraft von 1 µN bis 10 mN, bevorzugt bis 1 mN zu messen) bringt den Vorteil, dass man eine hohe Auflösung bzw. hohe Empfindlichkeit in einem großen Messbereich erreichen kann, die durch das inkrementelle Prinzip des entsprechenden Messkopfes herrührt und die mit den herkömmlichen Methoden nicht erreicht werden kann.

Ein Teil des Hintergrunds der vorliegenden Erfindung findet sich in den folgenden Überlegungen.

Generell ist für eine hohe Empfindlichkeit eine weiche Struktur erforderlich, die bei Wirken einer Kraft entsprechend stark nachgibt. Durch die relativ große Bewegung der weichen Struktur bei einer Kraftmessung ergibt sich eine entsprechende Positionsveränderung bzw. ein großer Positionsfehler. Zusätzlich wird der Messbereich durch das bei Absolutsensoren üblicherweise feste Verhältnis aus Auflösung zu Messbereich - der dynamische Messbereich - eingeschränkt. Dieses Problem kann dadurch überwunden werden, dass die wirkende Kraft, oder ein zu der wirkenden Kraft korrelierender Messwert, mit Hilfe eines Messkopfes, wie beispielsweise einem Interferometer, einem kapazitiven Messkopf oder einem optischen Encoder, gemessen wird, der bevorzugt ausgestaltet ist, eine Abstandsänderung von 0,1 nm bis 1 µm, bevorzugt bis 100 nm, zu messen bzw. wobei die Kraftbestimmungsvorrichtung ausgestaltet ist, eine Kraft von 1 µN bis 10 mN, bevorzugt bis 1 mN zu messen. Dadurch können bereits geringe Verbiegungen der Struktur detektiert werden, so dass dadurch der Positionsfehler geringgehalten werden kann, insbesondere ist eine Verbiegung der Struktur im Nanometerbereich detektierbar. Durch die hohe Messgenauigkeit des Messkopfes kann demnach eine Struktur mit hoher Steifigkeit verwendet werden, so dass eine hohe Auflösung in einem großen Messbereich erreicht werden kann. Ein großer Messbereich wird auch dadurch ermöglicht, dass der Messkopf, zum Beispiel ein Interferometer, ein kapazitiver Messkopf oder ein optischer Encoder inkrementell misst und damit unabhängig von der Auflösung ist.

In einer vorteilhaften Ausgestaltung eines Aspekts der Erfindung umfasst die Kraftbestimmungsvorrichtung bzw. die Messwertbestimmungsvorrichtung wenigstens einen Begrenzungsabschnitt, der ausgestaltet ist, ein Ausmaß des Nachgebens des flexiblen Abschnitts räumlich zu begrenzen. Der Begrenzungsabschnitt kann zum Beispiel als Stopper oder Endanschlag realisiert werden und ermöglicht, große Kräfte in einer Richtung der Begrenzungsabschnitte auszuüben. Dies ermöglicht eine Weiterverarbeitung der flachen Objekte mit hoher Kraftwirkung, zum Beispiel ein Bonden.

In einer anderen vorteilhaften Ausgestaltung eines Aspekts der Erfindung ist das Interferometer ausgestaltet, als die Messgröße eine Abstandsänderung zu messen. Im Fall, dass der Messkopf ein Interferometer umfasst, weist das Interferometer zumindest eine Strahlungsquelle, einen festen Spiegel, einen variablen Spiegel und einen Detektor auf, wobei die Strahlungsquelle ausgestaltet ist, eine elektromagnetische Strahlung auszusenden, die über den festen Spiegel und den variablen Spiegel auf den Detektor zurückfällt. Der feste Spiegel ist mit einem Bereich der Kraftbestimmungsvorrichtung bzw. der Messwertbestimmungsvorrichtung verbunden, der eine feste Position zu dem Interferometer aufweist. "Fest" heißt hierbei, dass sich eine Position des Spiegels während einer Messung nicht verändert, wohingegen "variabel" bedeutet, dass eine Position des Spiegels sich während einer Messung verändern kann. Insbesondere ist der variable Spiegel mit dem flexiblen Abschnitt verbunden, wobei eine Position des Spiegels durch eine Position des flexiblen Abschnitts definiert ist. Eine Abstandsänderung zwischen dem festen Spiegel und dem variablen Spiegel kann bevorzugt auf eine Kraft zurückgerechnet werden, die auf den flexiblen Abschnitt wirkt, so dass über die Abstandsänderung eine Kraft bestimmt werden kann.

Im Fall, dass der Messkopf einen kapazitiven Messkopf umfasst, ist der kapazitive Messkopf bevorzugt so in die Struktur integriert, dass das Nachgeben des flexiblen Abschnitts messbar ist. Besonders bevorzugt ist dafür eine kapazitiv wirkende Fläche vorgesehen. Beispielsweise kann der kapazitive Messkopf an dem flexiblen Abschnitt angeordnet sein. Dann ist in einem Fall, in dem eine kapazitiv wirkende Fläche vorgesehen ist, die kapazitiv wirkende Fläche an einem festen Abschnitt der Kraftbestimmungsvorrichtung angeordnet. Alternativ kann der kapazitive Messkopf an einem festen Abschnitt der Kraftbestimmungsvorrichtung angeordnet sein. Dann ist in einem Fall, in dem eine kapazitiv wirkende Fläche vorgesehen ist, die kapazitiv wirkende Fläche an dem flexiblen Abschnitt angeordnet.

Im Fall, dass der Messkopf einen optischen Encoder umfasst, ist bevorzugt ein Sensorstreifen an dem flexiblen Abschnitt angebracht, wobei weiter bevorzugt der optische Encoder ausgestaltet ist, eine Bewegung des Sensorstreifens zu erfassen. Dabei ist der optische Encoder an einem festen Abschnitt der Kraftbestimmungsvorrichtung angeordnet. Alternativ kann der optische Encoder an dem flexiblen Abschnitt angeordnet sein, wobei dann der Sensorstreifen an dem festen Abschnitt der Kraftbestimmungsvorrichtung angeordnet ist.

In einer anderen vorteilhaften Ausgestaltung eines Aspekts der Erfindung ist der flexible Abschnitt ausgestaltet, in eine vordefinierte Richtung nachzugeben, wenn eine Kraft zumindest anteilweise senkrecht zu einer Oberfläche des flexiblen Abschnitts in die vordefinierte Richtung wirkt. Dafür reicht es aus, dass der flexible Abschnitt eindimensional flexibel ist, so dass dann eine Kraft bzw. ein Messwert, der mit der Kraft korreliert, lediglich einem Betrag der Kraft bzw. einem Betrag des Messwertes, der mit der Kraft korreliert, in die vordefinierte Richtung entspricht.

In einer weiteren vorteilhaften Ausgestaltung eines Aspekts der Erfindung ist ein System zur Ausrichtung eines ersten Objekts zu einem zweiten Objekt vorgesehen, wobei das System eine Ausrichtungsvorrichtung und eine Kinematik umfasst. Die Ausrichtungsvorrichtung weist eine erste Kraftbestimmungsvorrichtung nach einer der obigen Ausgestaltungen auf, wobei das Kraftbestimmungsgerät der ersten Kraftbestimmungsvorrichtung ausgestaltet ist, als den Kraftwert einen ersten Kraftwert zu bestimmen, eine zweite Kraftbestimmungsvorrichtung nach einer der obigen Ausgestaltungen, wobei das Kraftbestimmungsgerät der zweiten Kraftbestimmungsvorrichtung ausgestaltet ist, als den Kraftwert einen zweiten Kraftwert zu bestimmen, und eine dritte Kraftbestimmungsvorrichtung nach einer der obigen Ausgestaltungen, wobei das Kraftbestimmungsgerät der dritten Kraftbestimmungsvorrichtung ausgestaltet ist, als den Kraftwert einen dritten Kraftwert zu bestimmen. Zudem weist die Ausrichtungsvorrichtung eine gemeinsame Struktur auf, die die erste Kraftbestimmungsvorrichtung, die zweite Kraftbestimmungsvorrichtung und die dritte Kraftbestimmungsvorrichtung miteinander verbindet und räumlich zueinander ausrichtet. Die Kinematik des Systems ist ausgestaltet, die Ausrichtungsvorrichtung in zumindest drei Freiheitsgraden zu bewegen, und weiter ausgestaltet, basierend auf dem ersten Kraftwert, dem zweiten Kraftwert und dem dritten Kraftwert das erste Objekt räumlich zu dem zweiten Objekt auszurichten.

In einer bevorzugten Variante der obigen Ausgestaltung entspricht die Kinematik einer 3D-Kinematik oder einer 6D-Kinematik. Besonders bevorzugt entspricht die Kinematik einer Parallelkinematik.

Weiter bevorzugt steht das erste Objekt mit dem Kontaktabschnitt der ersten Kraftbestimmungsvorrichtung, mit dem Kontaktabschnitt der zweiten Kraftbestimmungsvorrichtung und mit dem Kontaktabschnitt der dritten Kraftbestimmungsvorrichtung in Kontakt und wird an der gemeinsamen Struktur gehalten. Insbesondere steht das erste Objekt mit dem Kontaktabschnitt der ersten Kraftbestimmungsvorrichtung, mit dem Kontaktabschnitt der zweiten Kraftbestimmungsvorrichtung und mit dem Kontaktabschnitt der dritten Kraftbestimmungsvorrichtung über die gemeinsame Struktur in Kontakt.

In einer weiteren vorteilhaften Ausgestaltung eines Aspekts der Erfindung kann das Kraftbestimmungsverfahren zur Ausrichtung eines ersten Objekts zu einem zweiten Objekt verwendet werden. Das Verfahren zur Ausrichtung des ersten Objekts zu dem zweiten Objekt umfasst die Schritte: (i) Inkontaktbringen zumindest eines Teils des ersten Objekts mit einem Kontaktabschnitt einer ersten Kraftbestimmungsvorrichtung, einem Kontaktabschnitt einer zweiten Kraftbestimmungsvorrichtung und einem Kontaktabschnitt einer dritten Kraftbestimmungsvorrichtung, (ii) Nachgeben von flexiblen Abschnitten, die jeweils mit den Kontaktabschnitten verbunden sind, wenn eine Kraft zumindest teilweise auf das erste Objekt und/oder auf die Kontaktabschnitte wirkt, (iii) Messen von Messwerten einer Messgröße, die mit dem jeweiligen Nachgeben der flexiblen Abschnitte korreliert, mit Hilfe von Messköpfen, und (iv) räumliches Ausrichten des ersten Objekts zu dem zweiten Objekt basierend auf den Messwerten mit Hilfe einer Kinematik, die ausgestaltet ist, das erste Objekt in zumindest drei Freiheitsgraden zu bewegen.

Bevorzugt umfassen die Messköpfe jeweils ein Interferometer, einen kapazitiven Messkopf oder einen optischen Encoder, wobei die Messköpfe besonders bevorzugt identisch ausgestaltet sind.

Zusätzlich oder alternativ sind die Messköpfe jeweils ausgestaltet, als den jeweiligen Messwert eine Abstandsänderung von 0,1 nm bis 1 µm, bevorzugt bis 100 nm, zu messen und/oder wobei die erste Messwertbestimmungsvorrichtung, die zweite Messwertbestimmungsvorrichtung und die dritte Messwertbestimmungsvorrichtung jeweils ausgestaltet ist, eine Kraft von 1 µN bis 10 mN, bevorzugt bis 1 mN zu messen.

Somit kann die Kinematik basierend auf Messwerten, die mit Hilfe eines derartigen Messkopfes bestimmt bzw. gemessen werden, angesteuert werden. Dies führt zu einer hohen Genauigkeit, d.h. einer hohen Auflösung bzw. hohen Empfindlichkeit der Messungen und der Ansteuerung. Für das erfindungsgemäße System bzw. Verfahren kann weiter eine flexible Struktur mit einer hohen Steifigkeit gewählt werden, so dass in einem großen Messbereich Kraftwerte bestimmt werden können. Beispielsweise ergibt eine Empfindlichkeit von 5 nm bzw. 100 µN bei einem Messbereich von 10 N einen dynamischen Bereich von 100.000. Die Steifigkeit beträgt dabei ca. 20 N/mm. Der Messbereich ist dabei bevorzugt auch einstellbar und ergibt sich durch den Spalt bis zum Endanschlag. Alternativ sind auch andere Eigenschaften möglich, die zum Beispiel durch die Dicke des Biegebalkens bestimmt sind.

In einer vorteilhaften Ausgestaltung des Verfahrens umfasst das Verfahren den weiteren Schritt: (vi) räumliches Ausrichten des zweiten Objekts zu dem ersten Objekt basierend auf den Messwerten mit Hilfe einer weiteren Kinematik, die ausgestaltet ist, das zweite Objekt in zumindest drei Freiheitsgraden zu bewegen.

In einer anderen vorteilhaften Ausgestaltung des Verfahrens wird das erste Objekt zu dem zweiten Objekt derart ausgerichtet, dass die Messwerte jeweils vordefinierten Messwerten entsprechen, insbesondere gleich groß sind. Die vordefinierten Messwerte liegen bevorzugt nahe der Auflösungsgrenze, insbesondere bei einem Verfahren zur reinen Ausrichtung, oder bei größeren Werten bei einem Verfahren zum Bonden.

In einer anderen vorteilhaften Ausgestaltung umfasst das Verfahren ferner den Schritt: nach dem räumlichen Ausrichten, Beabstanden des ersten Objekts zu dem zweiten Objekt und/oder des zweiten Objekts zu dem ersten Objekt. Dies ist insbesondere dann gewünscht, wenn die beiden Objekte in einem vordefinierten Abstand und einem vordefinierten Winkel zueinander ausgerichtet werden sollen.

In einer weiteren vorteilhaften Ausgestaltung umfasst das Verfahren ferner den Schritt: Bestimmen von Kraftwerten, die zumindest teilweise auf das erste Objekt am jeweiligen Kontaktabschnitt und/oder auf den jeweiligen Kontaktabschnitt wirken, basierend auf den Messwerten der Messgröße, wobei das erste Objekt zu dem zweiten Objekt basierend auf den Kraftwerten räumlich ausgerichtet wird.

Bevorzugt umfasst die Kinematik eine erste Kinematik, die bevorzugt eine Parallelkinematik ist, mit mindestens drei Freiheitsgraden und eine zweite Kinematik, die auch als Antastsystem verstanden werden kann, mit ebenfalls mindestens drei Freiheitsgraden. Die zweite Kinematik ist in Bezug auf das erste Objekt unter bzw. hinter der ersten Kinematik angeordnet. Somit kann das erste Objekt zu dem zweiten Objekt hinsichtlich eines Abstands zwischen dem ersten Objekt und dem zweiten Objekt und einem Winkel zwischen den beiden Objekten ausgerichtet werden.

Der Kontaktabschnitt ist ein Abschnitt der Kraftbestimmungsvorrichtung, der mit zumindest einem Teil des ersten Objekts kontaktiert. Insbesondere kann der Kontaktabschnitt ausgestaltet sein, über einen Verbindungsabschnitt zumindest einen Teil des ersten Objekts zu kontaktieren. Der Kontaktabschnitt kontaktiert somit den Verbindungsabschnitt und der Verbindungsabschnitt kontaktiert zumindest einen Teil des ersten Objekts. Der Verbindungsabschnitt kann zum Beispiel die gemeinsame Struktur sein, wobei in diesem Fall der Kontaktabschnitt die gemeinsame Struktur kontaktiert und die gemeinsame Struktur kontaktiert zumindest einen Teil des ersten Objekts. Zusätzlich oder alternativ kann ein Element an dem ersten Objekt befestigt sein, so dass der Kontaktabschnitt nicht das erste Objekt direkt, sondern das daran befestigte Element kontaktiert. In jedem Fall ist der Kontaktabschnitt ausgestaltet, eine räumlich feste Beziehung zu dem ersten Objekt durch den Kontakt zu erhalten, so dass eine Kraft übertragen werden kann.

Der flexible Abschnitt ist mit dem Kontaktabschnitt verbunden, insbesondere strukturell verbunden, d.h. es handelt es sich um eine strukturelle Verbindung zwischen dem flexiblen Abschnitt und dem Kontaktabschnitt. In einer bevorzugten Ausführungsform sind der Kontaktabschnitt und der flexible Abschnitt einteilig ausgestaltet. Insbesondere weist die Kraftbestimmungsvorrichtung bzw. die Messwertbestimmungsvorrichtung einen Körper auf, wobei der Körper den flexiblen Abschnitt und den Kontaktabschnitt aufweist. Bevorzugt weist die Kraftbestimmungsvorrichtung bzw. die Messwertbestimmungsvorrichtung einen festen Abschnitt auf. Insbesondere ist der Kontaktabschnitt über den flexiblen Abschnitt mit dem festen Abschnitt verbunden. Bevorzugt umfasst der flexible Abschnitt wenigstens eine Verbindungsstrebe, besonders bevorzugt zwei Verbindungsstreben, wobei dann der Kontaktabschnitt über die Verbindungsstrebe bzw. die zwei Verbindungsstreben mit dem festen Abschnitt verbunden ist. Weiter besonders bevorzugt sind die zwei Verbindungsstreben in Richtung der Kraftausübung parallel zueinander ausgerichtet sind. Durch zwei Verbindungsstreben wird dann eine Parallelogrammstruktur definiert. Die Parallelogrammstruktur hat den Vorteil, dass bei der Kraftbestimmung bzw. Messwertbestimmung keine Winkeländerung die Messgenauigkeit herabsetzt.

Der flexible Abschnitt weist eine gewisse Flexibilität auf, d.h. bei Fixieren eines Teils des flexiblen Abschnitts, z.B. durch Verbindung mit dem festen Abschnitt, kann ein zweiter Teil des flexiblen Abschnitts bei Krafteinwirkung seine Position verändern. Insbesondere kann von einem Nachgeben, Verbiegen oder Verzerren des flexiblen Abschnitts bei Krafteinwirkung gesprochen werden. Die Flexibilität wird durch die Steifigkeit des flexiblen Abschnitts definiert, die insbesondere von einem Material des flexiblen Abschnitts, ihrer Dicke und/oder Ausformung etc. abhängt.

Im Fall, dass der Messkopf ein Interferometer umfasst, umfasst das Interferometer, wie oben angegeben, eine Strahlungsquelle, einen festen Spiegel, einen variablen Spiegel und einen Detektor. Der variable Spiegel ist bevorzugt an dem flexiblen Abschnitt oder dem Kontaktabschnitt angeordnet. Der feste Spiegel ist bevorzugt an dem festen Abschnitt angeordnet. Elektromagnetische Strahlung aus der Strahlungsquelle kann über den festen Spiegel und den variablen Spiegel zu dem Detektor gelangen, wobei eine Änderung der Position des variablen Spiegels, d.h. bevorzugt eine Änderung der Position des flexiblen Abschnitts oder des Kontaktabschnitts, in eine Kraft, die auf das erste Objekt wirkt, umgerechnet werden kann. Das Kraftbestimmungsgerät ist dann ausgestaltet, basierend auf dem Messwert der Messgröße einen Kraftwert der Kraft zu bestimmen, die zumindest teilweise auf das erste Objekt und/oder auf den Kontaktabschnitt wirkt.

Merkmale vorteilhafter Ausführungsformen der Erfindung sind insbesondere in den Unteransprüchen definiert, wobei weitere vorteilhafte Merkmale, Ausführungen und Ausgestaltungen für den Fachmann zudem aus den obigen Erläuterungen und der folgenden Diskussion zu entnehmen sind.

Im Folgenden wird die vorliegende Erfindung anhand von in den Figuren dargestellten Ausführungsbeispielen weiter illustriert und erläutert. Hierbei zeigt:
- Fig. 1: eine schematische Darstellung zur Illustration eines ersten Ausführungsbeispiels der Kraftbestimmungsvorrichtung,
- Fig. 2: eine schematische Darstellung zur Illustration eines zweiten Ausführungsbeispiels der Kraftbestimmungsvorrichtung,
- Fig. 3: eine schematische Darstellung zur Illustration eines dritten Ausführungsbeispiels der Kraftbestimmungsvorrichtung,
- Fig. 4: eine schematische Darstellung zur Illustration eines ersten Ausführungsbeispiels einer Ausrichtungsvorrichtung,
- Fig. 5: eine schematische Darstellung zur Illustration eines ersten Ausführungsbeispiels des Systems zur Ausrichtung eines ersten Objekts zu einem zweiten Objekt,
- Fig. 6: eine schematische Darstellung zur Illustration eines zweiten Ausführungsbeispiels des Systems zur Ausrichtung eines ersten Objekts zu einem zweiten Objekt,
- Fig. 7: ein schematisches Ablaufdiagramm eines Ausführungsbeispiels des Verfahrens zur Kraftbestimmung und
- Fig. 8: ein schematisches Ablaufdiagramm eines Ausführungsbeispiels des Verfahrens zur Ausrichtung eines ersten Objekts zu einem zweiten Objekt.

In den beiliegenden Zeichnungen sowie den Erläuterungen zu diesen Zeichnungen sind miteinander entsprechende bzw. in Beziehung stehende Elemente - soweit zweckdienlich - mit jeweils entsprechenden oder ähnlichen Bezugszeichen gekennzeichnet, auch wenn sie in unterschiedlichen Ausführungsbeispielen zu finden sind.

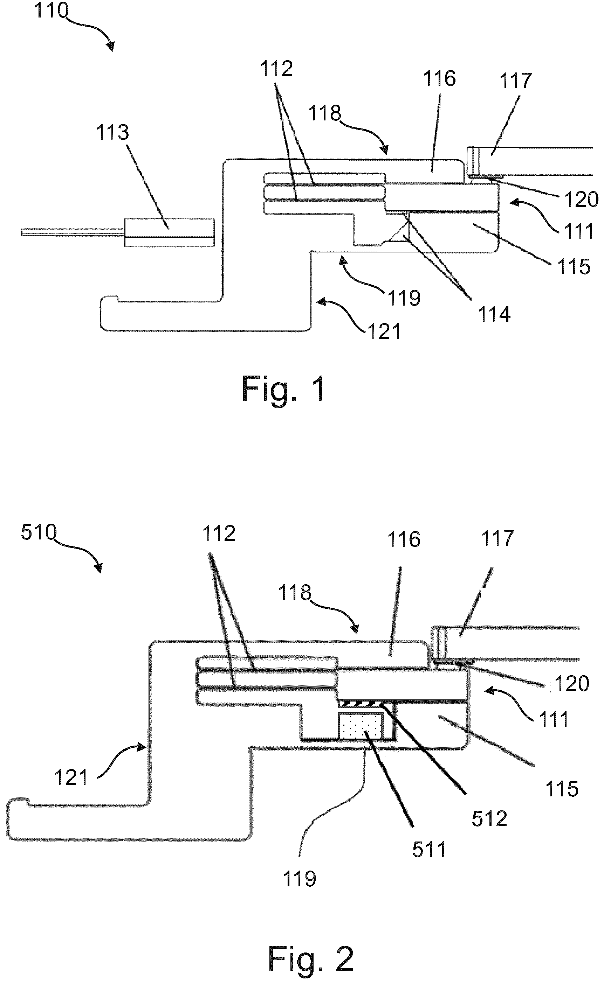

Fig. 1 zeigt eine schematische Darstellung zur Illustration eines ersten Ausführungsbeispiels der Kraftbestimmungsvorrichtung 110. Fig. 1 zeigt dabei einen Querschnitt der Kraftbestimmungsvorrichtung 110. Die Kraftbestimmungsvorrichtung 110 umfasst einen Kontaktabschnitt 111 und einen flexiblen Abschnitt 112. Zudem umfasst die Kraftbestimmungsvorrichtung 110 einen festen Abschnitt 119.

In der gezeigten Ausführungsform umfasst die Kraftbestimmungsvorrichtung 110 einen Winkel 121, der zur Befestigung zumindest eines Teils der Kraftbestimmungsvorrichtung 110 an einer Halterung, einem Tisch und/oder einer Kinematik vorgesehen ist. Die Befestigung kann dabei lösbar, zum Beispiel durch eine Schraube, oder nicht lösbar, zum Beispiel durch Kleben, realisiert werden. Die gezeigte Ausführungsform der Kraftbestimmungsvorrichtung 110 umfasst weiter einen vorstehenden Bereich 118, der von dem Winkel 121 vorsteht. Der vorstehende Bereich 118 umfasst insbesondere den Kontaktabschnitt 111, der ausgestaltet ist, zumindest einen Teil eines ersten Objekts zu kontaktieren. Insbesondere weist der Kontaktabschnitt 111 einen Kontaktpunkt 120 auf, der zumindest einen Teil des ersten Objekts kontaktiert. Der Kontaktabschnitt 111 bzw. der Kontaktpunkt 120 ist ausgestaltet, entweder direkt oder über einen Verbindungsabschnitt, der zum Beispiel als eine gemeinsame Struktur 117 ausgestaltet sein kann, zumindest einen Teil des ersten Objekts zu kontaktieren. Der vorstehende Bereich 118 umfasst in der vorliegenden Ausführungsform zudem einen Teil des flexiblen Abschnitts 112, wobei in dieser Ausführungsform der flexible Abschnitt 112 teilweise in dem Winkel 121 und teilweise in dem vorstehenden Bereich 118 angeordnet ist.

Der Kontaktpunkt 120 kann beispielsweise durch eine Kugel realisiert sein, die zwischen zwei Stäben entlanggleitet, so dass sich eine Führung entlang einer Linie ergibt (auch als kinematic mount bekannt). Zusätzlich kann in einer derartigen Anordnung über und unter der Kugel jeweils ein Magnet vorgesehen sein.

Der flexible Abschnitt 112 umfasst in der vorliegenden Ausführungsform zwei Verbindungsstreben, die im Querschnitt der Kraftbestimmungsvorrichtung 110 übereinander angeordnet sind. Beispielsweise kann der flexible Abschnitt 112, insbesondere die Verbindungsstreben, eine Länge von 17 mm aufweisen. Weiter kann eine Breite einer der Streben 15 mm betragen und eine Dicke 0,3 mm. Die Verbindungsstreben definieren eine Parallelogrammstruktur. Insbesondere ist der flexible Abschnitt 112 bzw. die Verbindungsstreben ausgestaltet, bei einer Krafteinwirkung auf den Kontaktabschnitt 111 seine bzw. ihre Geometrie zu verändern.

Der flexible Abschnitt 112 ist mit dem Kontaktabschnitt 111 verbunden. Weiter ist der flexible Abschnitt 112 ausgestaltet, nachzugeben, wenn eine Kraft zumindest teilweise auf das erste Objekt und/oder auf den Kontaktabschnitt 111 wirkt. Gibt der flexible Abschnitt 112 bei einer Krafteinwirkung, die zumindest teilweise auf das Objekt und/oder den Kontaktabschnitt 111 wirkt, nach, ändert sich die Geometrie des flexiblen Abschnitts 112. Insbesondere bewegt sich der Kontaktabschnitt 111 durch eine Krafteinwirkung in der Fig. 1 nach unten und die Verbindungsstreben bzw. die Parallelogrammstruktur werden/wird verzerrt.

Der feste Abschnitt 119, der flexible Abschnitt 112 und der Kontaktabschnitt 111 können zusammen auch als eine Cantilever-Struktur verstanden werden.

Weiter umfasst die Kraftbestimmungsvorrichtung 110 ein Interferometer. Das Interferometer umfasst wenigstens eine Strahlungsquelle und einen Detektor, die in der Figur mit dem Bezugszeichen 113 beschrieben werden, sowie zwei Spiegel 114. Insbesondere entsprechen die Spiegel 114 einem variablen Spiegel und einem festen Spiegel. Der variable Spiegel (in Fig. 1 der obere Spiegel) ist an dem Kontaktabschnitt 111 angeordnet und der feste Spiegel (in Fig. 1 der untere Spiegel) ist an dem festen Abschnitt 119 angeordnet. Der variable Spiegel an dem Kontaktabschnitt 111 ändert bei Veränderung der Geometrie des flexiblen Abschnitts 112 seine Position in Bezug auf den festen Spiegel an dem festen Abschnitt 119 bzw. in Bezug auf den festen Abschnitt. Alternativ zu einer Positionierung des festen Spiegels an dem festen Abschnitt 119 kann der feste Spiegel auch an jeder anderen Struktur befestigt werden, die eine feste räumliche Beziehung zu dem festen Abschnitt 119 und/oder der Strahlungsquelle und dem Detektor 113 des Interferometers aufweist, zum Beispiel an einer Halterung oder einem Tisch.

Die Bewegung des Kontaktabschnittes 111 durch eine Krafteinwirkung in der Fig. 1 nach unten führt zu einer Abstandsänderung der Spiegel 114 zueinander. Insbesondere wird der Abstand von dem variablen Spiegel zu dem festen Spiegel bei einer Krafteinwirkung nach unten verkleinert.

Auf Basis eines Interferenzsignals im Detektor 113 kann eine Abstandsänderung zwischen den beiden Spiegeln 114 detektiert werden. Die Abstandsänderung kann durch ein Kraftbestimmungsgerät (nicht gezeigt) direkt in eine Kraft, die zumindest teilweise auf das erste Objekt und/oder auf den Kontaktabschnitt 111 wirkt, umgerechnet werden.

Bevorzugt ist der flexible Abschnitt 112 ausgestaltet, in eine vordefinierte Richtung nachzugeben, bevorzugt in eine Richtung, die parallel zu einer Verbindung der beiden Spiegel 114 angeordnet ist.

In der gezeigten Ausführungsform der Kraftbestimmungsvorrichtung 110 umfasst der feste Abschnitt 119 wenigstens einen Begrenzungsabschnitt, hier die Begrenzungsabschnitte 115 und 116, die im Querschnitt der Kraftbestimmungsvorrichtung oberhalb und unterhalb des Kontaktabschnittes 111 vorgesehen sind. Insbesondere sind die Begrenzungsabschnitte 115 und 116 derart zu dem Kontaktabschnitt 111 angeordnet, dass sie den Kontaktabschnitt 111 bei Veränderung der Geometrie des flexiblen Abschnitts 112 räumlich begrenzen. Anders ausgedrückt umfasst die Kraftbestimmungsvorrichtung 110 einen unteren Begrenzungsabschnitt 115 und einen oberen Begrenzungsabschnitt 116, die ausgestaltet sind, ein Ausmaß des Nachgebens des flexiblen Abschnitts 112 nach oben bzw. nach unten räumlich zu begrenzen. Bei Vorliegen eines oberen Begrenzungsabschnitts 116 ist der Kontaktabschnitt 111 so ausgestaltet, dass er gegenüber dem oberen Begrenzungsabschnitt 116 vorsteht.

In Fig. 1 ist eine Kraftbestimmungsvorrichtung 110 gezeigt, wobei die gezeigte Vorrichtung auch einer Messwertbestimmungsvorrichtung entsprechen kann, wenn nicht eine Kraft, sondern ein anderer zu der Kraft in Beziehung stehender Messwert bestimmt bzw. gemessen wird.

Fig. 2 zeigt eine schematische Darstellung zur Illustration eines zweiten Ausführungsbeispiels der Kraftbestimmungsvorrichtung. Die Kraftbestimmungsvorrichtung 510 gemäß dem zweiten Ausführungsbeispiel entspricht im Wesentlichen der Kraftbestimmungsvorrichtung gemäß dem ersten Ausführungsbeispiel 110, so dass die Beschreibung von entsprechenden Bauteilen bzw. Elementen weggelassen wird.

Die Kraftbestimmungsvorrichtung 510 umfasst anstatt einem Interferometer einen kapazitiven Messkopf 511. In der gezeigten Ausführungsform ist der kapazitive Messkopf 511 an dem festen Abschnitt 119 angeordnet. Weiter weist die Kraftbestimmungsvorrichtung 510 eine kapazitiv wirkende Fläche 512 auf, die gegenüber des kapazitiven Messkopfes an dem flexiblen Abschnitt 112 angeordnet ist.

Alternativ kann der kapazitive Messkopf 511 auch an dem flexiblen Abschnitt 112 angeordnet sein, wobei dann, wenn eine kapazitiv wirkende Fläche 512 vorgesehen ist, die kapazitiv wirkende Fläche 512 an dem festen Abschnitt 119 angeordnet ist. Auch durch einen kapazitiven Messkopf 511 kann ein Nachgeben des flexiblen Abschnitts gemessen werden.

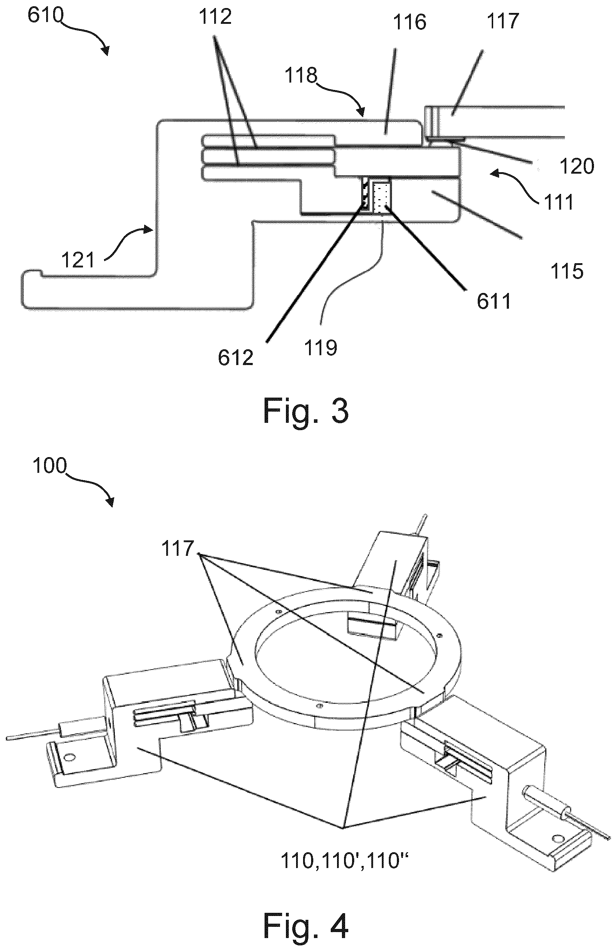

Fig. 3 zeigt eine schematische Darstellung zur Illustration eines dritten Ausführungsbeispiels der Kraftbestimmungsvorrichtung. Die Kraftbestimmungsvorrichtung 610 gemäß dem dritten Ausführungsbeispiel entspricht im Wesentlichen der Kraftbestimmungsvorrichtung 110 bzw. der Kraftbestimmungsvorrichtung 510, so dass die Beschreibung von entsprechenden Bauteilen bzw. Elementen weggelassen wird.

Die Kraftbestimmungsvorrichtung 610 umfasst anstatt einem Interferometer bzw. einem kapazitiven Messkopf einen optischen Encoder 611. In der gezeigten Ausführungsform ist der optische Encoder 611 an dem festen Abschnitt 119 angeordnet. Weiter weist die Kraftbestimmungsvorrichtung 610 einen Sensorstreifen 612 auf, der gegenüber des optischen Encoders an dem flexiblen Abschnitt 112 angeordnet ist.

Alternativ kann der optische Encoder 611 auch an dem flexiblen Abschnitt 112 angeordnet sein, wobei dann der Sensorstreifen an dem festen Abschnitt 119 angeordnet ist. Auch durch einen optischen Encoder als Messkopf kann ein Nachgeben des flexiblen Abschnitts gemessen werden.

Fig. 4 zeigt eine schematische Darstellung zur Illustration eines ersten Ausführungsbeispiels einer Ausrichtungsvorrichtung.

Die Ausrichtungsvorrichtung 100 in Fig. 4 umfasst eine erste Kraftbestimmungsvorrichtung 110, eine zweite Kraftbestimmungsvorrichtung 110' und eine dritte Kraftbestimmungsvorrichtung 110". Jede der ersten Kraftbestimmungsvorrichtung 110, der zweiten Kraftbestimmungsvorrichtung 110' und der dritten Kraftbestimmungsvorrichtung 110" ist ausgestaltet, einen Kraftwert zu bestimmen, wobei das Kraftbestimmungsgerät der ersten Kraftbestimmungsvorrichtung 110 ausgestaltet ist, als den Kraftwert einen ersten Kraftwert zu bestimmen, das Kraftbestimmungsgerät der zweiten Kraftbestimmungsvorrichtung 110', als den Kraftwert einen zweiten Kraftwert zu bestimmen und das Kraftbestimmungsgerät der dritten Kraftbestimmungsvorrichtung 110", als den Kraftwert einen dritten Kraftwert zu bestimmen.

Die Ausrichtungsvorrichtung 100 ist beispielhaft mit der Kraftbestimmungsvorrichtung 110 gezeigt, d.h. mit der Kraftbestimmungsvorrichtung 110, die ein Interferometer umfasst. Alternativ kann die Ausrichtungsvorrichtung 100 aber auch Kraftbestimmungsvorrichtungen 510, d.h. jeweils mit einem kapazitiven Messkopf, oder Kraftbestimmungsvorrichtungen 610, d.h. jeweils mit einem optischen Encoder umfassen. Dies gilt auch für die Ausrichtungsvorrichtung 100' sowie das System 200, 200' (s. unten).

Die erste Kraftbestimmungsvorrichtung 110, die zweite Kraftbestimmungsvorrichtung 110' und die dritte Kraftbestimmungsvorrichtung 110" sind über eine gemeinsame Struktur 117 miteinander verbunden und räumlich zueinander ausgerichtet. Die gemeinsame Struktur 117 ist hier als flacher Hohlzylinder ausgebildet, der auf den Kontaktbereichen der drei Kraftbestimmungsvorrichtungen aufliegt. Die gemeinsame Struktur 117, hier als flacher Hohlzylinder ausgebildet, kann beispielsweise einen Durchmesser von 50 mm aufweisen. Je größer der Abstand der Auflageflächen an den drei Messwertaufnehmern ist, desto besser ist die Winkelauflösung.

In der vorliegenden Ausführungsform weist die gemeinsame Struktur 117 in den Bereichen, in dem sie die Kontaktbereiche kontaktiert, einen verstärkten breiteren Bereich auf. Die erste Kraftbestimmungsvorrichtung 110, die zweite Kraftbestimmungsvorrichtung 110' und die dritte Kraftbestimmungsvorrichtung 110" sind jeweils ausgestaltet, auf einer gemeinsamen Halterung, einem Tisch und/oder einer Kinematik befestigt zu werden. Insbesondere kann die gemeinsame Halterung oder der Tisch eine Kinematik umfassen. Alternativ dazu können die erste Kraftbestimmungsvorrichtung 110, die zweite Kraftbestimmungsvorrichtung 110' und die dritte Kraftbestimmungsvorrichtung 110" auch direkt an der Kinematik befestigt sein.

In der gezeigten Ausführungsform kontaktiert der Kontaktabschnitt der jeweiligen Kraftbestimmungsvorrichtungen 110, 110', 110" die gemeinsame Struktur 117, wobei die gemeinsame Struktur 117 dann den zumindest einen Teil des ersten Objekts kontaktiert. Alternativ kann die gemeinsame Struktur 117 derart angeordnet sein, dass der Kontaktabschnitt der jeweiligen Kraftbestimmungsvorrichtung 110, 110', 110" den zumindest einen Teil des ersten Objekts direkt kontaktiert, wobei die gemeinsame Struktur 117 dann keinen Kontakt mit dem zumindest einen Teil des ersten Objekts hat.

Die Ausrichtungsvorrichtung 100 umfasst in der gezeigten Ausführungsform drei Kraftbestimmungsvorrichtungen 110, 110', 110", wobei alternativ die Ausrichtungsvorrichtung 100 auch drei Messwertbestimmungsvorrichtungen umfassen kann.

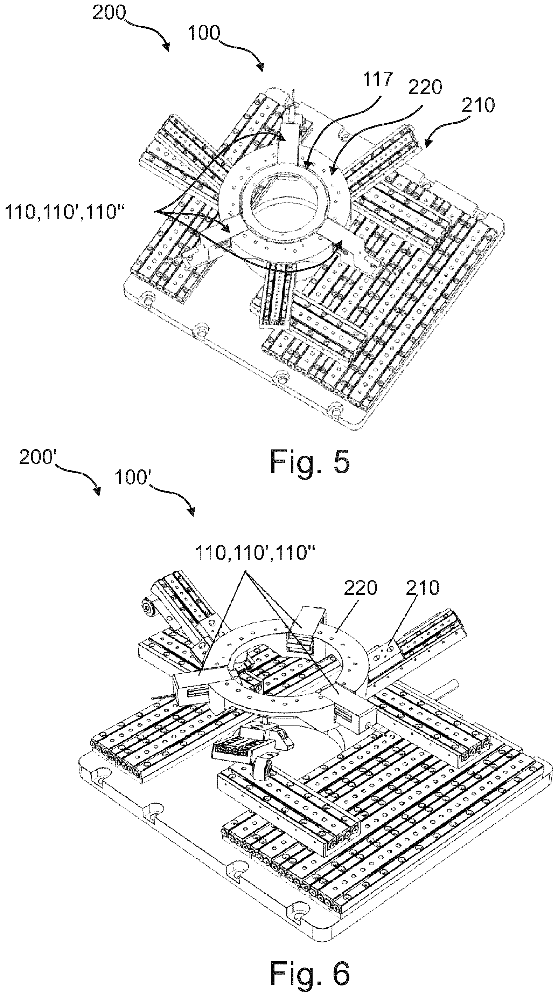

Fig. 5 zeigt eine schematische Darstellung zur Illustration eines ersten Ausführungsbeispiels des Systems zur Ausrichtung eines ersten Objekts zu einem zweiten Objekt.

Das System 200 zur Ausrichtung eines ersten Objekts zu einem zweiten Objekt weist drei Kraftbestimmungsvorrichtungen 110, 110' und 110" auf, die zusammen mit der gemeinsamen Struktur 117 die Ausrichtungsvorrichtung 100 bilden.

Die in Fig. 5 gezeigten Kraftbestimmungsvorrichtungen 110, 110' und 110" sind in einer gemeinsamen Halterung 220 eingebettet. In Fig. 5 ist zudem eine Kinematik 210 vorgesehen, die ausgestaltet ist, die Ausrichtungsvorrichtung 100 in zumindest drei Freiheitsgraden zu bewegen.

Fig. 6 zeigt eine schematische Darstellung zur Illustration eines zweiten Ausführungsbeispiels des Systems zur Ausrichtung eines ersten Objekts zu einem zweiten Objekt.

Die in Fig.6 gezeigten Kraftbestimmungsvorrichtungen 110, 110' und 110" weisen eine Geometrie auf, die sich zu der der Kraftbestimmungsvorrichtung 110 aus Fig. 1 bis 5 teilweise unterscheidet. Insbesondere weisen die Kraftbestimmungsvorrichtungen 110, 110' und 110" in Fig. 6 jeweils anstatt eines Winkels einen quaderförmigen Körper auf, wobei der flexible Abschnitt innerhalb des quaderförmigen Körpers angeordnet ist. Weiter weisen die Kraftbestimmungsvorrichtungen 110, 110' und 110", wie die in Fig. 1 bis 5 gezeigten, jeweils einen vorstehenden Abschnitt auf, an dem der Kontaktabschnitt angeordnet ist.

Fig. 5 und Fig. 6 unterscheiden sich von Prinzip her in den folgenden Punkten. Insbesondere ist die Anbindung des Interferometerkopfes unterschiedlich gelöst. Während in Fig. 5 ein Winkel vorhanden ist, auf dem eine Ausrichteinheit für den Sensorkopf untergebracht werden kann, ist der Interferometerkopf in Fig. 6 direkt in der Biegeeinheit, d.h. in dem festen Abschnitt 119, montiert. In Fig. 6 kann man dafür die Kugel des Kontaktpunktes 120 erkennen, weil in der Darstellung die gemeinsame Struktur 117 ausgeblendet ist.

Die gemeinsame Struktur 117 ist in Fig. 6 zur besseren Darstellung nicht gezeigt. Insbesondere ist so die Geometrie der gemeinsamen Halterung 220 und deren Verbindung zur Kinematik 210 besonders gut zu erkennen. In Fig. 6 ist wiederum eine Kinematik 210 vorgesehen, die ausgestaltet ist, die Ausrichtungsvorrichtung 100' in zumindest drei Freiheitsgraden zu bewegen. Insbesondere steht die Kinematik 210 mit der gemeinsamen Halterung 220 in Kontakt.

Die Kinematik 210 in Fig. 5 und 6 ist ausgestaltet, basierend auf dem ersten Kraftwert, dem zweiten Kraftwert und dem dritten Kraftwert das erste Objekt räumlich auszurichten. Insbesondere kann durch das System 200 in Fig. 5 bzw. das System 200' in Fig. 6 ein erstes Objekt räumlich zu einem zweiten Objekt ausgerichtet werden. Ein erstes Objekt, das mit dem System 200, 200' auszurichten ist, steht mit dem Kontaktabschnitt der ersten Kraftbestimmungsvorrichtung 110, mit dem Kontaktabschnitt der zweiten Kraftbestimmungsvorrichtung 110' und mit dem Kontaktabschnitt der dritten Kraftbestimmungsvorrichtung 110" über die gemeinsame Struktur 117 in Kontakt. Im Fall, dass anstatt von Kraftbestimmungsvorrichtung Messwertbestimmungsvorrichtungen verwendet werden, ist die Kinematik 210 ausgestaltet, basierend auf dem ersten Messwert, dem zweiten Messwert und dem dritten Messwert das erste Objekt räumlich auszurichten.

Die Kinematik 210 entspricht einer 6D-Kinematik, sie kann alternativ jedoch auch einer 3D-Kinematik entsprechen. Weiter entspricht die Kinematik 210 einer Parallelkinematik.

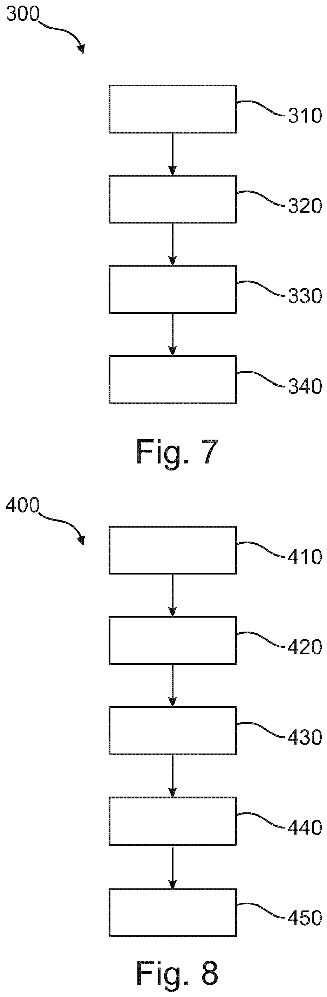

Fig. 7 zeigt ein schematisches Ablaufdiagramm eines Ausführungsbeispiels des Verfahrens zur Kraftbestimmung. Das Verfahren 300 umfasst zumindest die Schritte eines Inkontaktbringens 310, eines Nachgebens 320 eines flexiblen Abschnitts, eines Messens 330 eines Messwerts und eines Bestimmens 340 eines Kraftwerts. Schritt 310 umfasst insbesondere (i) ein Inkontaktbringen zumindest eines Teils eines ersten Objekts mit einem Kontaktabschnitt 111. Schritt 320 umfasst (ii) ein Nachgeben eines flexiblen Abschnitts 112, der mit dem Kontaktabschnitt 111 verbunden ist, während eine Kraft zumindest teilweise auf das erste Objekt und/oder auf den Kontaktabschnitt 111 wirkt. Schritt 330 umfasst (iii) ein Messen eines Messwerts einer Messgröße, die mit dem Nachgeben des flexiblen Abschnitts 112 korreliert. Schritt 340 umfasst (iv) ein Bestimmen eines Kraftwerts der Kraft, die zumindest teilweise auf das erste Objekt und/oder auf den Kontaktabschnitt wirkt, basierend auf dem Messwert der Messgröße.

Bevorzugt ist die Messgröße eine Abstandsänderung von 0,1 nm bis 1 µm, bevorzugt bis 100 nm, und/oder der Kraftwert im Bereich von 1 µN bis 10 mN, bevorzugt bis 1 mN. Insbesondere wird der Messwert bevorzugt von einem Interferometer, einem kapazitiven Messkopf oder einem optischen Encoder gemessen.

Fig. 8 zeigt ein schematisches Ablaufdiagramm eines Ausführungsbeispiels des Verfahrens zur Ausrichtung eines ersten Objekts zu einem zweiten Objekt. Das Verfahren 400 umfasst zumindest die Schritte eines Inkontaktbringens 410, eines Nachgebens 420 eines flexiblen Abschnitts, eines Messens 430 eines Messwerts und eines räumlichen Ausrichtens 450. Bevorzugt umfasst das Verfahren 400 zudem ein Bestimmen eines Kraftwerts 440. Schritt 410 umfasst (i) ein Inkontaktbringen zumindest eines Teils eines ersten Objekts mit einem Kontaktabschnitt einer ersten Kraftbestimmungsvorrichtung 110, einem Kontaktabschnitt einer zweiten Kraftbestimmungsvorrichtung 110' und einem Kontaktabschnitt einer dritten Kraftbestimmungsvorrichtung 110". Schritt 420 umfasst (ii) ein Nachgeben von flexiblen Abschnitten, die jeweils mit den Kontaktabschnitten verbunden sind, wenn eine Kraft zumindest teilweise auf das erste Objekt und/oder auf die Kontaktabschnitte wirkt. Schritt 430 umfasst (iii) ein Messen von Messwerten einer Messgröße, die mit dem jeweiligen Nachgeben der flexiblen Abschnitte korreliert,. Schritt 440 umfasst (iv) ein Bestimmen von Kraftwerten, die zumindest teilweise auf das erste Objekt am jeweiligen Kontaktabschnitt und/oder auf den jeweiligen Kontaktabschnitt wirken, basierend auf den Messwerten der Messgröße. Schritt 450 umfasst (v) ein räumliches Ausrichten des ersten Objekts zu dem zweiten Objekt basierend auf den Kraftwerten mit Hilfe einer Kinematik 210, die ausgestaltet ist, das erste Objekt in zumindest drei Freiheitsgraden zu bewegen.

Bevorzugt ist die Messgröße eine Abstandsänderung von 0,1 nm bis 1 µm, bevorzugt bis 100 nm, und/oder der Kraftwert im Bereich von 1 µN bis 10 mN, bevorzugt bis 1 mN. Insbesondere wird der Messwert bevorzugt von einem Interferometer, einem kapazitiven Messkopf oder einem optischen Encoder gemessen.

Weiter kann das Verfahren 400 einen Schritt 460 umfassen, wobei Schritt 460 ein räumliches Ausrichten des zweiten Objekts zu dem ersten Objekt basierend auf den Kraftwerten mit Hilfe einer weiteren Kinematik umfasst, die ausgestaltet ist, das zweite Objekt in zumindest drei Freiheitsgraden zu bewegen.

Insbesondere ist bevorzugt, das erste Objekt zu dem zweiten Objekt derart auszurichten, dass die bestimmten Kraftwerte jeweils vordefinierten Kraftwerten entsprechen, insbesondere gleich groß sind.

Weiter kann das Verfahren 400 einen Schritt 470 umfassen, der nach dem räumlichen Ausrichten ein Beabstanden des ersten Objekts zu dem zweiten Objekt und/oder des zweiten Objekts zu dem ersten Objekt umfasst.

Es ist zu beachten, dass zur Ausrichtung eines ersten Objekts zu einem zweiten Objekt mit dem erfindungsgemäßen System und/oder nach dem erfindungsgemäßen Verfahren nicht notwendigerweise aus dem Messwert, der mit dem jeweiligen Nachgeben der flexiblen Abschnitte korreliert, ein Kraftwert bestimmt wird, auf deren Basis dann das erste Objekt zu dem zweiten Objekt ausgerichtet wird. Vielmehr kann auch direkt aus dem Messwert, der mit dem jeweiligen Nachgeben der flexiblen Abschnitte korreliert, eine Berechnung durchgeführt werden, die für das räumliche Ausrichten des ersten Objekts zu dem zweiten Objekt vorgesehen ist.

Auch wenn in den Figuren verschiedene Aspekte oder Merkmale der Erfindung jeweils in Kombination gezeigt sind, ist für den Fachmann - soweit nicht anders angegeben - ersichtlich, dass die dargestellten und diskutierten Kombinationen nicht die einzig möglichen sind. Insbesondere können einander entsprechende Einheiten oder Merkmalskomplexe aus unterschiedlichen Ausführungsbeispielen miteinander ausgetauscht werden. Dies gilt insbesondere für die Kraftbestimmungsvorrichtungen aus Fig. 1 und denen der Fig. 6.

Es folgen weitere Überlegungen zu der Erfindung:
Die Kombination aus einer Parallelkinematik mit min. drei Freiheitsgraden und einem Antastsystem mit ebenfalls min. drei Freiheitsgraden direkt unter dem ersten Objekt ermöglicht es, kraftgeregelt ein zweites Objekt an drei Punkten anzutasten und somit das erste Objekt und das zweite Objekt in Abstand und Winkel zueinander auszurichten. Nach dem Antasten kann ein bestimmter Abstand eingestellt werden. Die flächigen Objekte benötigen keine bestimmten Vorrichtungen für die Ausrichtung. Sie müssen sich lediglich berühren dürfen.

Durch entsprechende Antriebs- und Messtechnik lassen sich teilweise sehr hohe Auflösungen bis in den Nanometer-Bereich erreichen. Zum Beispiel interferometrische Messungen kombinieren eine sehr hohe Auflösung mit einem Messbereich, der lediglich durch die flexible Struktur definiert wird. Durch die Verwendung eines "kinematic mounts" kann das bewegliche Objekt sich immer selbst zentrieren und komfortabel entnommen werden. Durch entsprechende Endanschläge in den flexiblen Strukturen können hohe Kräfte beim Bonden übertragen werden. Durch Reduzierung des Prinzips auf zwei oder einen Freiheitsgrad können auch Linienobjekte oder spitze Objekte angenähert werden.

Folgende Vorteile können durch die Erfindung erlangt werden: Es können beliebige flächige Objekte ausgerichtet werden. Zudem ist eine Ausrichtung in drei Freiheitsgraden, d.h. Abstand und Winkel, möglich. Weiter kann ein kraftgeregeltes Antasten und nachfolgendes Einstellen des Abstandes vorgenommen werden. Je nach Ausführung der Antriebs- und Messtechnik kann durch die Erfindung eine sehr hohe Auflösung erreicht werden.

Eine Ausführungsform der Erfindung kann wie folgt beschrieben werden: Das bewegliche Objekt wird von einer oder mehreren Cantilever-Strukturen gehalten, die die Kraft am jeweiligen Stützpunkt messen. Die Cantilever-Strukturen sind an einer gemeinsamen Struktur eines Bewegungssystems mit genügend Freiheitsgraden montiert. Das bewegliche Objekt wird in Richtung des festen Objekts bewegt, bis eine Kraft erkannt und mit Hilfe des Bewegungssystems an jedem Stützpunkt angepasst wird. Die Cantilever-Struktur umfasst eine flexible Struktur, die sich verformt, wenn eine äußere Kraft einwirkt. Das bewegliche Objekt wird am Stützpunkt der flexiblen Struktur gehalten, die durch die Verformung ihre Position ändert. Optional kann der Verformungsbereich durch mechanische Endanschläge begrenzt werden, wodurch eine hohe Kraft durch die Endanschläge an den jeweiligen Auflagepunkten ausgeübt werden kann. Die Kraft wird durch hochauflösende Messung der Verformung, insbesondere Laserinterferometer, gemessen, wobei das Interferometer dann einen Sensorkopf und zwei Spiegel umfasst.

Die Federkonstante, d. h. das Verhältnis von Kraft zu Verformung, der flexiblen Struktur kann durch Veränderung ihrer Geometrie angepasst werden. Es erlaubt, ein Optimum in Bezug auf Kraftempfindlichkeit und Arbeitsbereich zu definieren. Eine Messung mit hoher Auflösung ermöglicht es, eine hohe Kraftempfindlichkeit zu erreichen, während eine steife Unterstützung für das bewegliche Objekt aufrechterhalten wird. Die Auflagepunkte können Kugeln auf Linienkontakt - ähnlich wie bei kinematischen Halterungen - oder flexible Scharniere sein, damit sich die Cantilever-Strukturen in ihrer jeweiligen Messrichtung frei bewegen können, ohne die Position des beweglichen Objekts anderweitig zu beeinflussen.

Insbesondere kann die Kraftbestimmungsvorrichtung bzw. die Messwertbestimmungsvorrichtung in einer bevorzugten Ausführungsform als ein Interferometer-basierter taktiler Sensor verstanden werden. Dabei handelt es sich bevorzugt um eine Kombination aus Biegewandlern mit Interferometern in einer besonderen Struktur mit dem

Vorteil, dass man folgende Eigenschaften kombinieren kann, die eigentlich nicht kombinierbar sind: eine extrem hohe Auflösung (Verbiegung im nm-Bereich) bzw. Empfindlichkeit, eine hohe Steifigkeit der Struktur unter Einsatz der o.g. hohen Auflösung, um den Positionsfehler gering zu halten (ansonsten erfordert eine hohe Empfindlichkeit eine weiche Struktur, die entsprechend stark nachgibt) und einem großen Messbereich durch das inkrementelle Prinzip des Interferometers (bevorzugt mit einer Parallelogrammstruktur). Bevorzugt werden Endanschläge vorgesehen, die die Möglichkeit bringen, große Kräfte in einer Richtung über die Endanschläge auszuüben.

Eine wichtige Anwendung ist das Ausrichten zweier flacher Objekte zueinander, z.B. Wafer und Belichtungsmaske. Kräfte kann man damit auch messen, wenn die Sensoren entsprechend kalibriert sind, insbesondere ein Vergleich mit einer Referenz vorliegt.

Die Erfindung kann eine Kraftbestimmungsvorrichtung mit (i) einem Kontaktabschnitt umfassen, der ausgestaltet ist, zumindest einen Teil eines ersten Objekts zu kontaktieren, (ii) einem flexiblen Abschnitt, der mit dem Kontaktabschnitt verbunden ist, wobei der flexible Abschnitt ausgestaltet ist, nachzugeben, wenn eine Kraft zumindest teilweise auf das erste Objekt und/oder auf den Kontaktabschnitt wirkt, (iii) einem Messkopf, der ausgestaltet ist, einen Messwert einer Messgröße, die mit dem Nachgeben des flexiblen Abschnitts korreliert, zu messen, und (iv) einem Kraftbestimmungsgerät, das ausgestaltet ist, basierend auf dem Messwert der Messgröße einen Kraftwert der Kraft zu bestimmen, die zumindest teilweise auf das erste Objekt und/oder auf den Kontaktabschnitt wirkt. Insbesondere betrifft die Erfindung ein System mit zumindest drei Kraftbestimmungsvorrichtungen, wobei das System ausgestaltet ist, basierend auf drei Kraftwerten das erste Objekt räumlich zu dem zweiten Objekt auszurichten. Dadurch kann eine hohe Auflösung über einen großen Messbereich erreicht werden.

## Patentansprüche

1. System (200, 200') zur Ausrichtung eines ersten Objekts zu einem zweiten Objekt mit:
einer Ausrichtungsvorrichtung (100, 100'), die aufweist:
eine erste Messwertbestimmungsvorrichtung (110, 510, 610) mit
einem ersten Kontaktabschnitt, der ausgestaltet ist, zumindest einen ersten Teil eines ersten Objekts zu kontaktieren,
einem ersten flexiblen Abschnitt, der mit dem ersten Kontaktabschnitt verbunden ist, wobei der erste flexible Abschnitt ausgestaltet ist, nachzugeben, wenn eine Kraft zumindest teilweise auf das erste Objekt und/oder auf den ersten Kontaktabschnitt wirkt, und
einem ersten Messkopf, der ausgestaltet ist, einen ersten Messwert einer Messgröße, die mit dem Nachgeben des ersten flexiblen Abschnitts korreliert, zu messen,
eine zweite Messwertbestimmungsvorrichtung (110', 510, 610) mit
einem zweiten Kontaktabschnitt, der ausgestaltet ist, zumindest einen zweiten Teil eines ersten Objekts zu kontaktieren,
einem zweiten flexiblen Abschnitt, der mit dem zweiten Kontaktabschnitt verbunden ist, wobei der zweite flexible Abschnitt ausgestaltet ist, nachzugeben, wenn eine Kraft zumindest teilweise auf das erste Objekt und/oder auf den zweiten Kontaktabschnitt wirkt, und
einem zweiten Messkopf, der ausgestaltet ist, einen zweiten Messwert einer Messgröße, die mit dem Nachgeben des zweiten flexiblen Abschnitts korreliert, zu messen,
eine dritte Messwertbestimmungsvorrichtung (110', 510, 610) mit
einem dritten Kontaktabschnitt, der ausgestaltet ist, zumindest einen dritten Teil eines ersten Objekts zu kontaktieren, einem dritten flexiblen Abschnitt, der mit dem dritten Kontaktabschnitt verbunden ist, wobei der dritte flexible Abschnitt ausgestaltet ist, nachzugeben, wenn eine Kraft zumindest teilweise auf das erste Objekt und/oder auf den dritten Kontaktabschnitt wirkt, und
einem dritten Messkopf, der ausgestaltet ist, einen dritten Messwert einer Messgröße, die mit dem Nachgeben des dritten flexiblen Abschnitts korreliert, zu messen, und
eine gemeinsame Struktur (117), die die erste Messwertbestimmungsvorrichtung (110, 510, 610), die zweite Messwertbestimmungsvorrichtung (110', 510, 610) und die dritte Messwertbestimmungsvorrichtung (110", 510, 610) miteinander verbindet und räumlich zueinander ausrichtet, und
einer Kinematik (210), die ausgestaltet ist, die Ausrichtungsvorrichtung (100, 100') in zumindest drei Freiheitsgraden zu bewegen,
wobei die Kinematik (210) ferner ausgestaltet ist, basierend auf dem ersten Messwert, dem zweiten Messwert und dem dritten Messwert das erste Objekt räumlich zu dem zweiten Objekt auszurichten,
- wobei der erste Messkopf, der zweite Messkopf und der dritte Messkopf jeweils ein Interferometer, einen kapazitiven Messkopf oder einen optischen Encoder umfasst, wobei bevorzugt der erste Messkopf, der zweite Messkopf und der dritte Messkopf identisch ausgestaltet sind, und/oder
- wobei der erste Messkopf, der zweite Messkopf und der dritte Messkopf jeweils ausgestaltet ist, als den jeweiligen Messwert eine Abstandsänderung von 0,1 nm bis 1 µm, bevorzugt bis 100 nm, zu messen.

2. System (200, 200') nach Anspruch 1, wobei die Kinematik (210) einer 3D-Kinematik oder einer 6D-Kinematik entspricht.

3. System (200, 200') nach einem der Ansprüche 1 und 2, wobei die Kinematik (210) einer Parallelkinematik entspricht.

4. System (200, 200') nach einem der Ansprüche 1 bis 3, wobei das erste Objekt mit dem ersten Kontaktabschnitt der ersten Messwertbestimmungsvorrichtung (110, 510, 610), mit dem zweiten Kontaktabschnitt der zweiten Messwertbestimmungsvorrichtung (110', 510, 610) und mit dem dritten Kontaktabschnitt der dritten Messwertbestimmungsvorrichtung (110", 510, 610) in Kontakt steht und an der gemeinsamen Struktur (117) gehalten wird.

5. System (200, 200') nach einem der Ansprüche 1 bis 4, wobei die erste Messwertbestimmungsvorrichtung (110, 510, 610), die zweite Messwertbestimmungsvorrichtung (110', 510, 610) und die dritte Messwertbestimmungsvorrichtung (110", 510, 610) jeweils einer Kraftbestimmungsvorrichtung (110, 510, 610, 110', 110") entspricht, wobei jede der Kraftbestimmungsvorrichtungen (110, 510, 610, 110', 110") umfasst:
einen Kontaktabschnitt (111), der ausgestaltet ist, zumindest einen Teil des ersten Objekts zu kontaktieren,
einen flexiblen Abschnitt (112), der mit dem Kontaktabschnitt (111) verbunden ist, wobei der flexible Abschnitt (112) ausgestaltet ist, nachzugeben, wenn eine Kraft zumindest teilweise auf das erste Objekt und/oder auf den Kontaktabschnitt (111) wirkt,
einen Messkopf (113, 114, 511, 611), der ausgestaltet ist, einen Messwert einer Messgröße, die mit dem Nachgeben des flexiblen Abschnitts (112) korreliert, zu messen, und
ein Kraftbestimmungsgerät, das ausgestaltet ist, basierend auf dem Messwert der Messgröße einen Kraftwert der Kraft zu bestimmen, die zumindest teilweise auf das erste Objekt und/oder auf den Kontaktabschnitt (111) wirkt,
- wobei der Messkopf ein Interferometer (113, 114), einen kapazitiven Messkopf (511) oder einen optischen Encoder (611) umfasst und/oder
- wobei der Messkopf ausgestaltet ist, als die Messgröße eine Abstandsänderung von 0,1 nm bis 1 µm, bevorzugt bis 100 nm, zu messen und/oder wobei die Kraftbestimmungsvorrichtung (110, 510, 610, 110', 110") ausgestaltet ist, eine Kraft von 1 µN bis 10 mN, bevorzugt bis 1 mN zu messen.

6. System (200, 200') nach Anspruch 5, wobei jede der Kraftbestimmungsvorrichtungen (110, 510, 610, 110', 110") ferner wenigstens einen Begrenzungsabschnitt (115, 116) umfasst, der ausgestaltet ist, ein Ausmaß des Nachgebens des flexiblen Abschnitts (112) räumlich zu begrenzen.

7. System (200, 200') nach einem der Ansprüche 5 und 6, wobei der Messkopf jeder der Kraftbestimmungsvorrichtungen (110, 510, 610, 110', 110") ein Interferometer (113, 114) umfasst, wobei das Interferometer (113, 114) ausgestaltet ist, als die Messgröße eine Abstandsänderung zu messen.

8. System (200, 200') nach einem der Ansprüche 5 bis 7, wobei der flexible Abschnitt (112) jeder der Kraftbestimmungsvorrichtungen (110, 510, 610, 110', 110") ausgestaltet ist, in eine vordefinierte Richtung nachzugeben, wenn eine Kraft zumindest anteilweise senkrecht zu einer Oberfläche des flexiblen Abschnitts (112) in die vordefinierte Richtung wirkt.

9. Verfahren (400) zur Ausrichtung eines ersten Objekts zu einem zweiten Objekt mit den Schritten:
Inkontaktbringen (410) zumindest eines Teils eines ersten Objekts mit einem ersten Kontaktabschnitt einer ersten Messwertbestimmungsvorrichtung (110, 510, 610), einem zweiten Kontaktabschnitt einer zweiten Messwertbestimmungsvorrichtung (110', 510, 610) und einem dritten Kontaktabschnitt einer dritten Messwertbestimmungsvorrichtung (110", 510, 610),
Nachgeben (420) von flexiblen Abschnitten, die jeweils mit den Kontaktabschnitten verbunden sind, wenn eine Kraft zumindest teilweise auf das erste Objekt und/oder auf die Kontaktabschnitte wirkt,
Messen (430) von Messwerten einer Messgröße, die mit dem jeweiligen Nachgeben der flexiblen Abschnitte korreliert, und
räumliches Ausrichten (450) des ersten Objekts zu dem zweiten Objekt basierend auf den Messwerten mit Hilfe einer Kinematik (210), die ausgestaltet ist, das erste Objekt in zumindest drei Freiheitsgraden zu bewegen,
- wobei die Messwerte der Messgrößen mit Hilfe von Interferometern, kapazitiven Messköpfen oder optischen Encodern gemessen werden und/oder
- wobei die Messgrößen jeweils eine Abstandsänderung von 0,1 nm bis 1 µm, bevorzugt bis 100 nm, umfassen.

10. Verfahren (400) nach Anspruch 9, das ferner den Schritt umfasst:
räumliches Ausrichten des zweiten Objekts zu dem ersten Objekt basierend auf den Messwerten mit Hilfe einer weiteren Kinematik, die ausgestaltet ist, das zweite Objekt in zumindest drei Freiheitsgraden zu bewegen.

11. Verfahren (400) nach einem der Ansprüche 9 und 10, wobei das erste Objekt zu dem zweiten Objekt derart ausgerichtet wird, dass die Messwerte jeweils vordefinierten Messwerten entsprechen, insbesondere gleich groß sind.

12. Verfahren (400) nach einem der Ansprüche 9 bis 11, das ferner den Schritt umfasst:
nach dem räumlichen Ausrichten, Beabstanden des ersten Objekts zu dem zweiten Objekt und/oder des zweiten Objekts zu dem ersten Objekt.

13. Verfahren (400) nach einem der Ansprüche 9 bis 12, das ferner den Schritt umfasst:
Bestimmen (440) von Kraftwerten, die zumindest teilweise auf das erste Objekt am jeweiligen Kontaktabschnitt und/oder auf den jeweiligen Kontaktabschnitt wirken, basierend auf den Messwerten der Messgröße,
wobei das erste Objekt zu dem zweiten Objekt basierend auf den Kraftwerten räumlich ausgerichtet wird.

14. Verfahren (400) nach Anspruch 13, wobei das Bestimmen (440) von Kraftwerten umfasst:
Inkontaktbringen (310) zumindest eines Teils des ersten Objekts mit dem jeweiligen Kontaktabschnitt (111),
Nachgeben (320) des jeweiligen flexiblen Abschnitts (112), der mit dem Kontaktabschnitt (111) verbunden ist, wenn eine Kraft zumindest teilweise auf das erste Objekt und/oder auf den Kontaktabschnitt (111) wirkt,
Messen (330) des jeweiligen Messwerts der Messgröße, die mit dem Nachgeben des flexiblen Abschnitts (112) korreliert, und
Bestimmen (340) des jeweiligen Kraftwerts der Kraft, die zumindest teilweise auf das erste Objekt und/oder auf den Kontaktabschnitt wirkt, basierend auf dem jeweiligen Messwert der Messgröße,
- wobei der jeweilige Messwert der Messgröße mit Hilfe eines Interferometers, eines kapazitiven Messkopfes oder eines optischen Encoders gemessen wird und/oder
- wobei die jeweilige Messgröße eine Abstandsänderung von 0,1 nm bis 1 µm, bevorzugt bis 100 nm, umfasst und/oder wobei der jeweilige Kraftwert einen Wert von 1 µN bis 10 mN, bevorzugt bis 1 mN umfasst.

## Claims

1. A system (200, 200') for aligning a first object with a second object, comprising:
an alignment apparatus (100, 100') comprising:
a first measurement value determination apparatus (110, 510, 610) with
a first contact section configured to contact at least a first portion of a first object,
a first flexible section connected to the first contact section, wherein the first flexible section is configured to yield when a force acts at least partially on the first object and/or on the first contact section, and
a first measuring head configured to measure a first measurement value of a measured variable that correlates with the yielding of the first flexible section,
a second measurement value determination apparatus (110', 510, 610) with
a second contact section configured to contact at least a second portion of a first object,
a second flexible section connected to the second contact section, wherein the second flexible section is configured to yield when a force acts at least partially on the first object and/or on the second contact section, and
a second measuring head configured to measure a second measurement value of a measured variable that correlates with the yielding of the second flexible section,
a third measurement value determination apparatus (110', 510, 610) with
a third contact section configured to contact at least a third portion of a first object,
a third flexible section connected to the third contact section, wherein the third flexible section is configured to yield when a force acts at least partially on the first object and/or on the third contact section, and
a third measuring head configured to measure a third measurement value of a measured variable that correlates with the yielding of the third flexible section, and
a common structure (117) that connects the first measurement value determination apparatus (110, 510, 610), the second measurement value determination apparatus (110', 510, 610), and the third measurement value determination apparatus (110'', 510, 610) to each other, and aligns them spatially with each other, and
a kinematic mechanism (210) configured to move the alignment apparatus (100, 100') in at least three degrees of freedom,
wherein the kinematic mechanism (210) is further configured to spatially align the first object with the second object based on the first measurement value, the second measurement value, and the third measurement value,
- wherein the first measuring head, the second measuring head, and the third measuring head each comprise an interferometer, a capacitive measuring head, or an optical encoder, wherein the first measuring head, the second measuring head, and the third measuring head are preferably configured identically, and/or
- wherein the first measuring head, the second measuring head, and the third measuring head are each configured to measure a distance change of 0.1 nm to 1 µm, preferably up to 100 nm, as the respective measurement value.

2. The system (200, 200') according to claim 1, wherein the kinematic mechanism (210) corresponds to a 3D kinematic mechanism or a 6D kinematic mechanism.

3. The system (200, 200') according to any one of claims 1 and 2, wherein the kinematic mechanism (210) corresponds to a parallel kinematic mechanism.

4. The system (200, 200') according to any one of claims 1 to 3, wherein the first object is in contact with the first contact section of the first measurement value determination apparatus (110, 510, 610), with the second contact section of the second measurement value determination apparatus (110', 510, 610), and with the third contact section of the third measurement value determination apparatus (110'', 510, 610), and is held on the common structure (117).

5. The system (200, 200') according to any one of claims 1 to 4, wherein the first measurement value determination apparatus (110, 510, 610), the second measurement value determination apparatus (110', 510, 610) and the third measurement value determination apparatus (110'', 510, 610) each correspond to a force determination apparatus (110, 510, 610, 110', 110''), wherein each of the force determination apparatuses (110, 510, 610, 110', 110'') comprises:
a contact section (111) configured to contact at least a portion of a first object,
a flexible section (112) connected to the contact section (111), wherein the flexible section (112) is configured to yield when a force acts at least partially on the first object and/or on the contact section (111),
a measuring head (113, 114, 511, 611) configured to measure a measurement value of a measured variable that correlates with the yielding of the flexible section (112), and
a force determination device configured to determine, based on the measurement value of the measured variable, a force value of the force acting at least partially on the first object and/or on the contact section (111),
- wherein the measuring head comprises an interferometer (113, 114), a capacitive measuring head (511), or an optical encoder (611) and/or
- wherein the measuring head is configured to measure a distance change of 0.1 nm to 1 µm, preferably up to 100 nm, as the measured variable, and/or wherein the force determination apparatus (110, 510, 610, 110', 110'') is configured to measure a force of 1 µN to 10 mN, preferably up to 1 mN.

6. The system (200, 200') according to claim 5, wherein each of the force determination apparatuses (110, 510, 610, 110', 110'') further comprises at least one limiting section (115, 116) that is configured to spatially limit an extent of yielding of the flexible section (112).

7. The system (200, 200') according to any of claims 5 and 6, wherein the measuring head of each of the force determination apparatuses (110, 510, 610, 110', 110'') comprises an interferometer (113, 114), wherein the interferometer (113, 114) is configured to measure a distance change as the measured variable.

8. The system (200, 200') according to any of claims 5 to 7, wherein the flexible section (112) of each of the force determination apparatuses (110, 510, 610, 110', 110'') is configured to yield in a predefined direction when a force acts at least partially perpendicular to a surface of the flexible section (112) in the predefined direction.

9. A method (400) for aligning a first object with a second object, comprising the steps of:
bringing (410) at least a portion of a first object into contact with a first contact section of a first measurement value determination apparatus (110, 510, 610), a second contact section of a second measurement value determination apparatus (110', 510, 610), and a third contact section of a third measurement value determination apparatus (110'', 510, 610),
yielding (420) of flexible sections connected to the respective contact sections when a force acts at least partially on the first object and/or on the contact sections,
measuring (430) measurement values of a measured variable that correlates with the respective yielding of the flexible sections, and
spatially aligning (450) the first object with the second object based on the measurement values using a kinematic mechanism (210) that is configured to move the first object in at least three degrees of freedom,
- wherein the measurement values of the measured variables are measured using interferometers, capacitive measuring heads, or optical encoders, and/or
- wherein the measured variables each comprise a distance change of 0.1 nm to 1 µm, preferably up to 100 nm.

10. The method (400) according to claim 9, further comprising the step of:
spatially aligning the second object with the first object based on the measurement values using a further kinematic mechanism that is configured to move the second object in at least three degrees of freedom.

11. The method (400) according to one of claims 9 and 10, wherein the first object is aligned with the second object in such a way that the measurement values correspond to predefined measurement values, in particular are equal in size.

12. The method (400) according to one of claims 9 to 11, further comprising the step of:
after spatial aligning, spacing the first object from the second object and/or the second object from the first object.

13. The method (400) according to one of claims 9 to 12, further comprising the step of:
determining (440) force values that act at least partially on the first object at the respective contact section and/or on the respective contact section, based on the measurement values of the measured variable,
wherein the first object is spatially aligned with the second object based on the force values.

14. The method (400) according to claim 13, wherein the determining (440) of force values comprises the steps of:
bringing (310) at least a portion of the first object into contact with the respective contact section (111),
yielding (320) the respective flexible section (112) connected to the contact section (111) when a force acts at least partially on the first object and/or on the contact section (111),
measuring (330) the respective measurement value of the measured variable that correlates with the yielding of the flexible section (112), and
determining (340) the respective force value of the force acting at least partially on the first object and/or on the contact section based on the respective measurement value of the measured variable,
- wherein the respective measurement value of the measured variable is measured using an interferometer, a capacitive measuring head, or an optical encoder, and/or
- wherein the respective measured variable comprises a distance change of 0.1 nm to 1 µm, preferably up to 100 nm, and/or wherein the respective force value comprises a value of 1 µN to 10 mN, preferably up to 1 mN.

## Revendications

1. Système (200, 200') d'alignement d'un premier objet par rapport à un deuxième objet, comprenant :
un dispositif d'alignement (100, 100') comprenant :
un premier dispositif de détermination de valeur de mesure (110, 510, 610) comprenant
une première section de contact, configurée pour contacter au moins une première partie d'un premier objet,
une première section flexible, reliée à la première section de contact, la première section flexible étant configurée pour fléchir lorsqu'une force agit au moins partiellement sur le premier objet et/ou sur la première section de contact, et
une première tête de mesure, configurée pour mesurer une première valeur mesurée d'une grandeur de mesure corrélée au fléchissement de la première section flexible,
un deuxième dispositif de détermination de valeur de mesure (110', 510, 610) comprenant
une deuxième section de contact, configurée pour contacter au moins une deuxième partie d'un premier objet,
une deuxième section flexible, reliée à la deuxième section de contact, la deuxième section flexible étant configurée pour fléchir lorsqu'une force agit au moins partiellement sur le premier objet et/ou sur la deuxième section de contact, et
une deuxième tête de mesure, configurée pour mesurer une deuxième valeur mesurée d'une grandeur de mesure corrélée au fléchissement de la deuxième section flexible,
un troisième dispositif de détermination de valeur de mesure (110', 510, 610) comprenant
une troisième section de contact, configurée pour contacter au moins une troisième partie d'un premier objet,
une troisième section flexible, reliée à la troisième section de contact, la troisième section flexible étant configurée pour fléchir lorsqu'une force agit au moins partiellement sur le premier objet et/ou sur la troisième section de contact, et
une troisième tête de mesure, configurée pour mesurer une troisième valeur mesurée d'une grandeur de mesure corrélée au fléchissement de la troisième section flexible, et
une structure commune (117), qui relie entre eux le premier dispositif de détermination de valeur de mesure (110, 510, 610), le deuxième dispositif de détermination de valeur de mesure (110', 510, 610) et le troisième dispositif de détermination de valeur de mesure (110'', 510, 610) et les aligne spatialement les uns par rapport aux autres, et
une cinématique (210), configurée pour déplacer le dispositif d'alignement (100, 100') selon au moins trois degrés de liberté,
la cinématique (210) étant en outre configurée pour aligner spatialement le premier objet par rapport au deuxième objet sur la base de la première valeur mesurée, de la deuxième valeur mesurée et de la troisième valeur mesurée,
- dans lequel la première tête de mesure, la deuxième tête de mesure et la troisième tête de mesure comprennent chacune un interféromètre, une tête de mesure capacitive ou un codeur optique, de préférence la première tête de mesure, la deuxième tête de mesure et la troisième tête de mesure étant configurées de manière identique, et/ou
dans lequel la première tête de mesure, la deuxième tête de mesure et la troisième tête de mesure sont chacune configurées pour mesurer, en tant que valeur mesurée respective, une variation de distance de 0,1 nm à 1 µm, de préférence jusqu'à 100 nm.

2. Système (200, 200') selon la revendication 1, dans lequel la cinématique (210) correspond à une cinématique 3D ou à une cinématique 6D.

3. Système (200, 200') selon l'une des revendications 1 et 2, dans lequel la cinématique (210) correspond à une cinématique parallèle.

4. Système (200, 200') selon l'une des revendications 1 à 3, dans lequel le premier objet est en contact avec la première section de contact du premier dispositif de détermination de valeur de mesure (110, 510, 610), avec la deuxième section de contact du deuxième dispositif de détermination de valeur de mesure (110', 510, 610) et avec la troisième section de contact du troisième dispositif de détermination de valeur de mesure (110'', 510, 610), et est maintenu sur la structure commune (117).

5. Système (200, 200') selon l'une des revendications 1 à 4, dans lequel le premier dispositif de détermination de valeur de mesure (110, 510, 610), le deuxième dispositif de détermination de valeur de mesure (110', 510, 610) et le troisième dispositif de détermination de valeur de mesure (110'', 510, 610) correspondent chacun à un dispositif de détermination de force (110, 510, 610, 110', 110''), chacun des dispositifs de détermination de force (110, 510, 610, 110', 110'') comprenant :
une section de contact (111), configurée pour contacter au moins une partie du premier objet,
une section flexible (112), reliée à la section de contact (111), la section flexible (112) étant configurée pour fléchir lorsqu'une force agit au moins partiellement sur le premier objet et/ou sur la section de contact (111),
une tête de mesure (113, 114, 511, 611), configurée pour mesurer une valeur mesurée d'une grandeur de mesure corrélée au fléchissement de la section flexible (112), et
un dispositif de détermination de force, configuré pour déterminer, sur la base de la valeur mesurée de la grandeur de mesure, une valeur de force de la force agissant au moins partiellement sur le premier objet et/ou sur la section de contact (111),
- dans lequel la tête de mesure comprend un interféromètre (113, 114), une tête de mesure capacitive (511) ou un codeur optique (611), et/ou
- dans lequel la tête de mesure est configurée pour mesurer, en tant que grandeur de mesure, une variation de distance de 0,1 nm à 1 µm, de préférence jusqu'à 100 nm, et/ou dans lequel le dispositif de détermination de force (110, 510, 610, 110', 110'') est configuré pour mesurer une force de 1 µN à 10 mN, de préférence jusqu'à 1 mN.

6. Système (200, 200') selon la revendication 5, dans lequel chacun des dispositifs de détermination de force (110, 510, 610, 110', 110'') comprend en outre au moins une section de limitation (115, 116), configurée pour limiter spatialement une amplitude du fléchissement de la section flexible (112).

7. Système (200, 200') selon l'une des revendications 5 et 6, dans lequel la tête de mesure de chacun des dispositifs de détermination de force (110, 510, 610, 110', 110'') comprend un interféromètre (113, 114), l'interféromètre (113, 114) étant configuré pour mesurer, en tant que grandeur de mesure, une variation de distance.

8. Système (200, 200') selon l'une des revendications 5 à 7, dans lequel la section flexible (112) de chacun des dispositifs de détermination de force (110, 510, 610, 110', 110'') est configurée pour fléchir dans une direction prédéfinie lorsqu'une force agit au moins en partie perpendiculairement à une surface de la section flexible (112) dans la direction prédéfinie.

9. Procédé (400) d'alignement d'un premier objet par rapport à un deuxième objet, comprenant les étapes suivantes :
mettre en contact (410) d'au moins une partie d'un premier objet avec une première section de contact d'un premier dispositif de détermination de valeur de mesure (110, 510, 610), une deuxième section de contact d'un deuxième dispositif de détermination de valeur de mesure (110', 510, 610) et une troisième section de contact d'un troisième dispositif de détermination de valeur de mesure (110'', 510, 610),
fléchir (420) par des sections flexibles, reliées chacune aux sections de contact, lorsqu'une force agit au moins partiellement sur le premier objet et/ou sur les sections de contact,
mesurer (430) de valeurs mesurées d'une grandeur de mesure corrélée au fléchissement respectif des sections flexibles, et
aligner (450) spatialement du premier objet par rapport au deuxième objet sur la base des valeurs mesurées à l'aide d'une cinématique (210), configurée pour déplacer le premier objet selon au moins trois degrés de liberté,
- dans lequel les valeurs mesurées des grandeurs de mesure sont mesurées à l'aide d'interféromètres, de têtes de mesure capacitives ou de codeurs optiques, et/ou
- dans lequel les grandeurs de mesure comprennent chacune une variation de distance de 0,1 nm à 1 µm, de préférence jusqu'à 100 nm.

10. Procédé (400) selon la revendication 9, comprenant en outre l'étape suivante :
aligner spatialement du deuxième objet par rapport au premier objet sur la base des valeurs mesurées à l'aide d'une autre cinématique, configurée pour déplacer le deuxième objet selon au moins trois degrés de liberté.

11. Procédé (400) selon l'une des revendications 9 et 10, dans lequel le premier objet est aligné par rapport au deuxième objet de telle sorte que les valeurs mesurées correspondent chacune à des valeurs mesurées prédéfinies, en particulier sont d'égale grandeur.

12. Procédé (400) selon l'une des revendications 9 à 11, comprenant en outre l'étape suivante :
après l'alignement spatial, la mise à distance du premier objet par rapport au deuxième objet et/ou du deuxième objet par rapport au premier objet.

13. Procédé (400) selon l'une des revendications 9 à 12, comprenant en outre l'étape suivante :
déterminer (440) des valeurs de force agissant au moins partiellement sur le premier objet au niveau de la section de contact respective et/ou sur la section de contact respective, sur la base des valeurs mesurées de la grandeur de mesure,
dans lequel le premier objet est aligné spatialement par rapport au deuxième objet sur la base des valeurs de force.

14. Procédé (400) selon la revendication 13, dans lequel la détermination (440) de valeurs de force comprend :
mettre en contact (310) d'au moins une partie du premier objet avec la section de contact (111) respective,
fléchir (320) par de la section flexible (112) respective, reliée à la section de contact (111), lorsqu'une force agit au moins partiellement sur le premier objet et/ou sur la section de contact (111),
mesurer (330) de la valeur mesurée respective de la grandeur de mesure corrélée au fléchissement de la section flexible (112), et
déterminer (340) de la valeur de force respective de la force agissant au moins partiellement sur le premier objet et/ou sur la section de contact, sur la base de la valeur mesurée respective de la grandeur de mesure,
- dans lequel la valeur mesurée respective de la grandeur de mesure est mesurée à l'aide d'un interféromètre, d'une tête de mesure capacitive ou d'un codeur optique, et/ou
- dans lequel la grandeur de mesure respective comprend une variation de distance de 0,1 nm à 1 µm, de préférence jusqu'à 100 nm, et/ou dans lequel la valeur de force respective comprend une valeur de 1 µN à 10 mN, de préférence jusqu'à 1 mN.
